(19) Europäisches Patentamt / European Patent Office / Office européen des brevets

(11) **EP 2 769 378 B1**

(12) **FASCICULE DE BREVET EUROPEEN**

(45) Date de publication et mention
de la délivrance du brevet:
**16.12.2015 Bulletin 2015/51**

(21) Numéro de dépôt: **12787785.0**

(22) Date de dépôt: **19.10.2012**

(51) Int Cl.:
**G10L 19/00** (2013.01)      **G10L 19/002** (2013.01)
**G10L 19/24** (2013.01)

(86) Numéro de dépôt international:
**PCT/FR2012/052400**

(87) Numéro de publication internationale:
**WO 2013/057453 (25.04.2013 Gazette 2013/17)**

(54) **CODAGE HIERARCHIQUE PERFECTIONNE**

VERBESSERTE HIERARCHISCHE KODIERUNG

IMPROVED HIERARCHICAL CODING

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **19.10.2011 FR 1159425**

(43) Date de publication de la demande:
**27.08.2014 Bulletin 2014/35**

(73) Titulaire: **Orange
75015 Paris (FR)**

(72) Inventeur: **LAMBLIN, Claude
F-22730 Tregastel (FR)**

(74) Mandataire: **Cabinet Plasseraud
52, rue de la Victoire
75440 Paris Cedex 09 (FR)**

(56) Documents cités:
**EP-A2- 2 187 387**

EP 2 769 378 B1

**Description**

La présente invention concerne le codage/décodage de signaux numériques, notamment dans des applications de transmission ou de stockage de signaux numériques tels que des signaux audio (parole et/ou sons) ou vidéo, ou plus généralement multimédia.

Elle concerne en particulier un codage/décodage numérique, du type logarithmique mis en oeuvre par exemple par le codeur UIT-T G.711.1.

La compression de signaux pour réduire le débit tout en maintenant une bonne qualité de perception peut faire appel à de nombreuses techniques, parmi :

- la technique MIC ("Modulation par Impulsions et Codage") ou « PCM » (pour "Pulse Code Modulation" en anglais), et ses variantes telles que l'ADPCM (pour "Adaptive Differential PCM"),
- les techniques CELP (pour "Code Excited Linear Prediction") et
- les techniques dites « par transformée » (par exemple de type MDCT, pour "Modified Discrete Cosine Transformation").

La technique PCM compresse le signal, échantillon par échantillon, avec un nombre de bits donné tandis que les autres types de techniques compressent des blocs d'échantillons (ou trames).

Le codage/décodage selon la recommandation UIT-T G.711 est l'un des plus utilisés pour les signaux de parole, tant en téléphonie traditionnelle (via le réseau commuté) que via l'Internet (en voix sur IP ou « VoIP »). Un tel codage utilise la technique dite « MIC logarithmique ».

On rappelle ci-après le principe du codage/décodage selon la recommandation UIT-T G.711.

Le codeur G.711 est basé sur une compression logarithmique sur 8 bits à la fréquence d'échantillonnage de 8 kHz, pour donner un débit de 64 kbit/s.

Le principe du codage MIC G.711 est d'opérer une compression des signaux filtrés dans la bande [300 ; 3400 Hz] par une courbe logarithmique qui permet d'obtenir un rapport signal à bruit à peu près constant pour une large dynamique de signaux. Il s'agit d'un codage par quantification dont le pas de quantification varie avec l'amplitude de l'échantillon à coder :

- quand le niveau du signal d'entrée est faible, le pas de quantification est petit,
- quand le niveau du signal d'entrée est élevé, le pas de quantification est grand.

Deux lois de compression MIC logarithmique sont utilisées :

- la loi $\mu$ (utilisée en Amérique du Nord et au Japon) et
- la loi A (utilisée en Europe et dans le reste du monde).

Le codage G.711 selon la loi A et le codage G.711 selon la loi $\mu$ encodent sur 8 bits les échantillons d'entrée.

En pratique, pour faciliter la mise en oeuvre du codeur G.711, la compression MIC logarithmique a été approximée par une courbe en segments.

Dans la loi A, les 8 bits sont répartis de la façon suivante :

- 1 bit de signe,
- 3 bits pour indiquer le segment,
- 4 bits pour indiquer l'emplacement sur le segment.

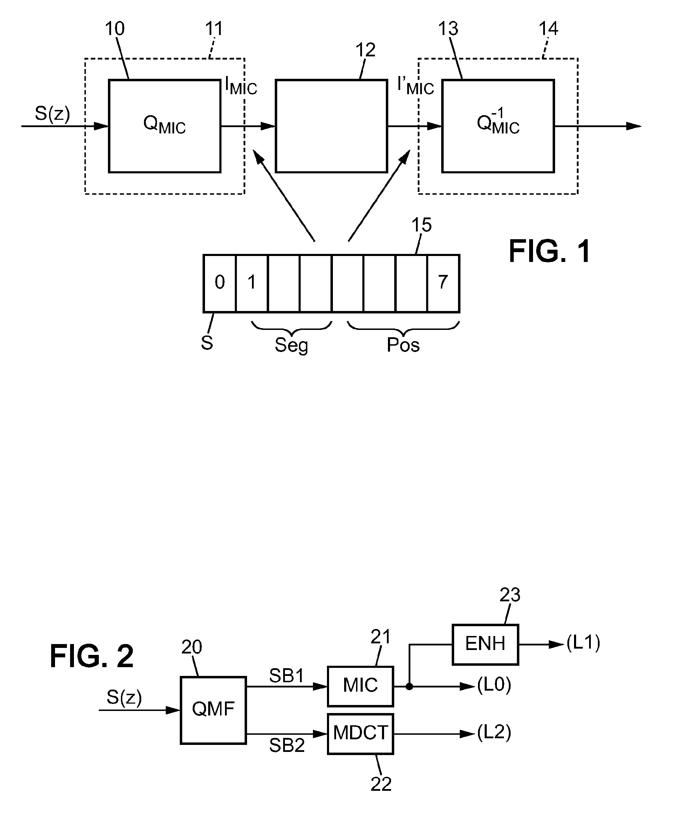

On rappelle le principe du codage/décodage MIC en référence à la figure 1. Le codeur MIC 11 comporte un module de quantification $Q_{MIC}$ 10 qui reçoit en entrée le signal d'entrée S(z). L'indice de quantification $I_{MIC}$ en sortie du module de quantification 10 est transmis via le canal de transmission 12 au décodeur 14. Le décodeur MIC 14 reçoit en entrée les indices $I'_{MIC}$ issus du canal de transmission (version éventuellement perturbée par des erreurs binaires de $I_{MIC}$), et réalise une quantification inverse par le module de quantification inverse 13 ($Q^{-1}_{MIC}$) pour obtenir le signal décodé. Le codage MIC normalisé UIT-T G.711 (ci-après nommé G.711) réalise une compression de l'amplitude des signaux par une courbe logarithmique avant quantification scalaire uniforme, ce qui permet d'obtenir un rapport signal à bruit à peu près constant pour une large dynamique de signaux. Le pas de quantification dans le domaine du signal original est donc proportionnel à l'amplitude des signaux. Les échantillons successifs du signal compressé sont quantifiés sur 8 bits, soit 256 niveaux.

Un indice de quantification $I_{MIC}$ (portant la référence 15 dans l'exemple représenté sur la figure 1) peut donc être considéré comme la représentation d'un nombre en virgule flottante avec 4 bits de mantisse « Pos », 3 bits d'exposant « Seg » et un bit de signe « S ».

Dans la représentation binaire (signe et valeur absolue) de l'échantillon à coder sur 16 bits, en notant $b_0$ le bit de poids le plus faible d'un échantillon (ou « LSB » pour "Least Significant Bit"), l'exposant indique la position *pos* du premier "1" parmi les positions 14 à 8, les bits de mantisse étant alors les 4 bits suivants, le bit de signe étant le bit $b_{15}$.

Ainsi, si la position *pos*=14, *exp*=7 ; si *pos*=13, *exp*=6, ..., si *pos*=8, *exp*=1.

Si le premier "1" est après la position 8 (ce qui correspond à une valeur absolue de l'échantillon à coder inférieure ou égale à 255), l'exposant vaut 0.

Dans un exemple donné dans la table ci-après où le premier bit à "1" est le bit $b_{10}$ (*pos*=10), l'exposant *exp* vaut 3, et les 4 bits de la mantisse sont les 4 bits des positions 9 à 6: $m_3 m_2 m_1 m_0 (=b_9 b_8 b_7 b_6)$.

| $b_{15}$ | $b_{14}$ | $b_{13}$ | $b_{12}$ | $b_{11}$ | $b_{10}$ | $b_9$ | $b_8$ | $b_7$ | $b_6$ | $b_5$ | $b_4$ | $b_3$ | $b_2$ | $b_1$ | $b_0$ |
|---|---|---|---|---|---|---|---|---|---|---|---|---|---|---|---|
| s | 0 | 0 | 0 | 0 | 1 | $m_3$ | $m_2$ | $m_1$ | $m_0$ | | | | | | |

L'encodage de type G.711 d'un signal numérique peut s'effectuer par comparaison aux seuils de décision du quantificateur, une recherche par dichotomie permettant d'accélérer les calculs. Cette recherche par comparaison à des seuils nécessite le stockage des seuils de décision et des indices de quantification correspondant aux seuils. Une autre solution d'encodage, moins coûteuse en calcul, consiste à éliminer les 4 bits de poids faible par un décalage de 4 bits à droite, puis en additionnant 2048 à la valeur décalée. L'indice de quantification est obtenu finalement par une simple lecture d'une table à 4096 entrées, ce qui nécessite toutefois une mémoire morte (ROM) plus importante que dans le procédé présenté ci-dessus.

Pour éviter le stockage de tels tableaux, l'indice de quantification peut être déterminé avec des opérations simples de faible complexité. Tel est le cas dans l'encodeur G.711.1. On prévoit toujours un décalage à droite d'au moins 4 bits. Pour des échantillons à coder sur 16 bits, le plus petit pas de quantification reste 16. Les 4 bits de poids faible sont toujours perdus.

Plus généralement, seuls sont transmis les 4 bits suivant le premier bit à "1" : les autres bits sont perdus. Ainsi :

- dans le premier segment ($|x| \leq 255$, *exp*= 0), les 4 bits les moins significatifs sont perdus (*mant*= x»4) ; et
- dans les autres segments ($2^{exp+7} \leq |x| < 2^{exp+8}$, 0<*exp*<8), les (3+*exp*) bits les moins significatifs sont perdus (*mant*= x>>(3+*exp*)).

Le nombre de bits perdus augmente donc avec le numéro du segment, jusqu'à 10 bits pour le dernier segment (*exp*= 7).

Au décodeur, le signal décodé est obtenu à la sortie du quantificateur MIC inverse (figure 1). Si la quantification inverse est mise en oeuvre par une table, elle consiste simplement en un pointage par l'indice dans la table des 256 valeurs décodées. Le décodage peut aussi être fait par des opérations simples de même type.

La version selon la loi $\mu$ est assez similaire. La principale différence est l'addition de 128 aux valeurs pour assurer que dans le premier segment, le bit 7 soit toujours égal à 1. Une telle réalisation permet :

- de rendre inutile la transmission du bit 7,
- d'augmenter néanmoins la précision du codage dans le premier segment (le pas de quantification étant égal à 8 dans le premier segment contre 16 dans le codage selon la loi A),
- de traiter de manière identique tous les segments.

De plus, on additionne 4 (donc 128+4 = 132 au total) pour l'arrondi et ainsi avoir le niveau « 0 » parmi les valeurs quantifiées (la loi A n'ayant pas de niveau 0, les plus petites valeurs étant $\pm 8$). Le prix de cette meilleure résolution dans le premier segment est le décalage de tous les segments par 132. Comme pour la loi A, le décodage est réalisé soit par lecture de table soit par un jeu d'opérations algorithmiquement simples.

Le rapport signal à bruit (RSB) obtenu par le codage MIC est à peu près constant (~38 dB) pour une large dynamique de signaux. Le pas de quantification dans le domaine du signal original est proportionnel à l'amplitude des signaux. Ce rapport signal à bruit n'est pas suffisant pour rendre le bruit de quantification inaudible. De plus, pour les faibles niveaux de signal (premier segment) le rapport RSB est très mauvais et peut même être négatif.

La qualité du codeur G.711 est jugée comme bonne pour les signaux de parole en bande étroite (fréquence d'échantillonnage à 8 kHz). Cependant, cette qualité n'est pas excellente et la différence entre le signal original à coder et le signal décodé est perceptible avec un bruit de codage audible. Dans certaines applications, il est nécessaire de pouvoir augmenter la qualité du codage MIC dans la bande [0 ; 4000 Hz] en ajoutant une couche optionnelle par exemple de 16 kbit/s (donc 2 bits par échantillon). Quand le décodeur reçoit cette couche d'amélioration, il peut améliorer la qualité du signal décodé.

On présente ci-après un principe du codage/décodage G.711 dit « hiérarchique ».

Dans le cas du codage G.711, codeur peu complexe et peu coûteux en mémoire, il est intéressant de considérer une technique d'extension hiérarchique ayant aussi une complexité faible et des besoins en mémoire raisonnables. Une telle technique (telle qu'elle a été décrite par exemple dans le document US-2010/191538) consiste à récupérer les bits non transmis dans la mantisse du codage MIC et à les transmettre dans la couche d'amélioration. En cas de réception de cette couche, le décodeur peut décoder la mantisse avec une plus grande précision. Cette technique, qui permet d'obtenir une augmentation du rapport RSB de 6 dB pour chaque bit ajouté par échantillon, consiste à sauvegarder et à transmettre dans un flux binaire d'amélioration les bits de poids fort parmi les bits perdus lors du codage MIC initial. Par exemple, dans le cas d'une couche d'amélioration à 16 kbit/s (2 bits par échantillon), les bits à envoyer dans cette couche peuvent être obtenus en effectuant le décalage à droite en deux étapes pour sauvegarder les 2 bits qui suivent les 4 bits de la mantisse.

L'encodeur envoie dans la couche d'extension les bits correspondant aux premiers bits (poids fort) des bits qui seraient autrement perdus à cause de la précision limitée du codage MIC logarithmique. Ces bits d'extension permettent d'ajouter des emplacements supplémentaires sur les segments « Seg », en enrichissant donc l'information sur les échantillons d'amplitudes les plus élevées. Le décodeur concatène les bits d'extension reçus derrière les bits de la couche de base pour obtenir une plus grande précision de l'emplacement de l'échantillon décodé dans le segment. Au décodeur, la valeur d'arrondi est adaptée en fonction du nombre de bits d'extension reçus.

Cette technique de récupération des bits non transmis dans la mantisse du codage MIC, pour les transmettre dans une couche d'amélioration, est utilisée pour améliorer le codage de la bande basse dans le codeur UIT-T G.711.1.

Le codeur UIT-T G.711.1, version 2008, est une extension du codage MIC G.711. Il s'agit d'un codeur hiérarchique de 64 à 96 kbit/s pleinement interopérable avec le codeur G.711 (loi A ou loi$\mu$). Ce standard répond aux besoins d'amélioration de qualité des applications de VoIP. Le schéma de principe du codage/décodage G.711.1 est donné à la figure 2. Le codeur G.711.1 opère sur des signaux audio échantillonnés à 16 kHz sur des blocs ou trames de 5 ms (soit 80 échantillons à 16 kHz). Le signal d'entrée S(z) est divisé en deux sous-bandes SB1 : [0, 4 kHz] et SB2 : [4 kHz , 8 kHz] par des filtres 20 de type QMF (pour « Quadrature Mirror Filters »). Le débit de 64 kbit/s ("Layer 0" compatible avec G.711 (L0)) correspond à la quantification de la sous-bande [0, 4 kHz] par la technique MIC (module 21) équivalente au codage G.711 présenté ci-avant, avec une mise en forme du bruit de quantification. Les deux couches suivantes (« Layers 1 - 2 ») codent respectivement :

- la bande basse [0, 4 kHz] en utilisant une technique d'amélioration (ENH) du codage MIC (module d'amélioration 23 pour la couche « Layer 1 » (L1)),
- et la bande haute [4, 8 kHz] par un codage par transformée MDCT (module 22 pour la couche « Layer 2 » (L2)),

chacune avec un débit de 16 kbit/s (80 bits par trame).

La couche d'amélioration (« Layer 1 ») de la bande basse permet de réduire l'erreur de quantification de la couche coeur (« Layer 0 »), en ajoutant des bits supplémentaires à chaque échantillon codé selon la recommandation G.711. Comme indiqué précédemment, elle ajoute des bits additionnels de mantisse à chaque échantillon.

Le nombre de bits additionnels pour la mantisse dépend de l'amplitude d'échantillon. En effet, plutôt que d'allouer le même nombre de bits pour améliorer la précision du codage de mantisse des échantillons, les 80 bits disponibles dans la couche 1 (L1) pour améliorer la précision du codage de mantisse des 40 échantillons sont alloués dynamiquement, plus de bits étant attribués aux échantillons avec un fort exposant. Ainsi, tandis que le budget de bits de la couche d'amélioration est de 2 bits par échantillon en moyenne (16 kbit/s), le signal d'amélioration a une résolution de 3 bits par échantillon et, avec cette allocation adaptative, le nombre de bits alloués à un échantillon varie selon sa valeur d'exposant de 0 à 3 bits.

On décrit ci-après comment s'opère le codage/décodage de la couche « 1 » (L1) d'amélioration de la bande basse du codeur G.711.1.

L'encodage avec allocation binaire adaptative s'effectue en deux phases :

- une première phase de génération de la table d'allocation binaire,
- suivie d'une phase de multiplexage dynamique du signal d'amélioration.

La procédure est commune aux deux lois A et $\mu$.

La table d'allocation binaire est générée en utilisant les exposants des 40 échantillons, *exp(n)*, avec *n*=0 à *n*=39. La procédure de génération de la table d'allocation binaire comporte elle-même deux étapes :

- dans une première étape, une carte d'exposants et une table de compteurs d'index d'exposants sont calculées à partir des exposants et

- dans une deuxième étape, on calcule la table d'allocation binaire.

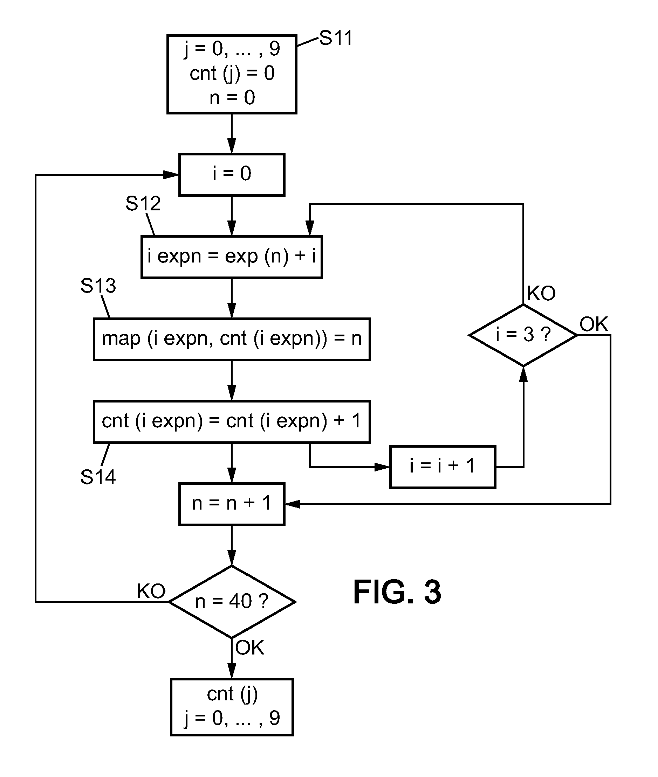

Une carte d'exposants, *map(j,n)*, *j*=0, .., 9, *n*=0,..,39, et une table de compteurs d'index d'exposants, *cnt(j)*, *j*=0, .., 9, sont calculées selon les opérations suivantes, en référence à la figure 3 sur laquelle l'étape S11 consiste en une initialisation à zéro de la table de compteurs d'index d'exposants: *cnt(j)*=0, *j*=0,...9 et d'un indice *n* de boucle sur les 40 échantillons.

Ensuite, pour chacun des 40 échantillons (avec une boucle sur *n*=0,..,39),

(dans une boucle sur *i*=0,..,2)

  ◦ l'étape S12 correspond à un calcul de trois index d'exposant: *iexpn= exp(n)+i, i*= 0, 1, 2;,
  ◦ l'étape S13 correspond à une mise à jour de la carte d'exposants: *map(iexpn,cnt(iexpn))= n*
  ◦ l'étape S14 correspond à une incrémentation de la table des compteurs d'index d'exposants : *cnt(iexpn)=cnt(iexpn)+1*

A la fin de cette procédure, la table des compteurs d'index d'exposants *cnt(j)* indique le nombre d'échantillons avec le même index d'exposant et la carte d'exposants contient les indices des échantillons qui utilisent un index d'exposant donné.

Ainsi, *cnt*(6) est le nombre d'échantillons pouvant avoir comme index d'exposant 6, c'est-à-dire le nombre d'échantillons tels que leur exposant est égal à 6 (*i*=0), 5 (*i*=1), ou 4 (*i*=2), *map(6,j)*, *j*=0, *cnt*(6)-1, contenant alors les indices de ces *cn*t(6) échantillons.

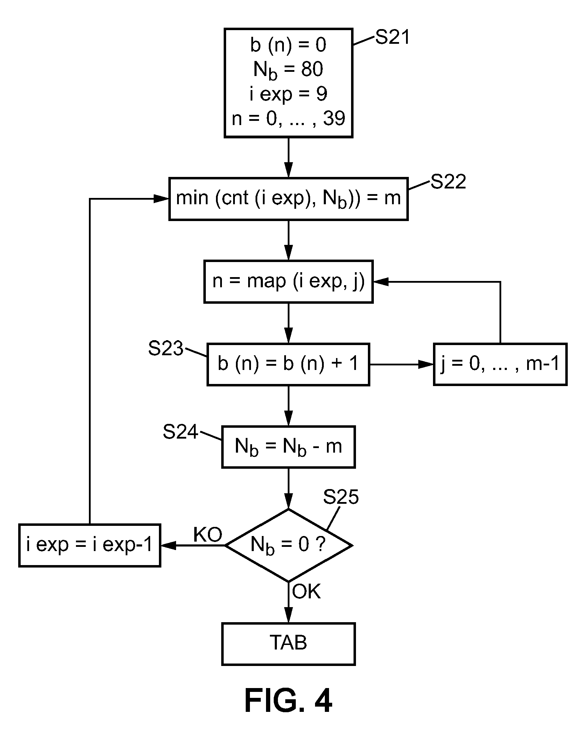

La table d'allocation binaire, *b(n)*, *n*=0, ..., 39, est alors calculée comme suit, en référence à la figure 4, sur laquelle l'étape S21 consiste en une initialisation:

- de la table d'allocation binaire, *b(n)*, à zéro: *b(n)*=0, *n*=0, ..., 39,
- du nombre de bits à allouer $N_b$ à 80: $N_b$=80
- de l'index d'exposant, *iexp*, à sa valeur maximale (ici, 9 =7+2): *iexp*= 9

Après cette première étape d'initialisation, les étapes S22 à S25 suivantes sont itérées jusqu' à ce que tous les bits soient alloués :

S22 : Comparaison du nombre de bits à allouer $N_b$ avec le compteur d'index d'exposants, *cnt(iexp)*, pour déterminer le plus petit des deux: *min(cnt(iexp), $N_b$)*

S23 : Incrémentation de 1 de l'allocation binaire des min(*cnt(iexp)*, $N_b$) premiers échantillons dont les indices correspondent à l'index d'exposant *iexp* dans la carte d'exposants:

  *b(n) = b(n)* +1, pour tout *n = map(iexp j)*, *j*= 0, ..., min(*cnt(iexp)*, $N_b$)-1,

S24 : Mise à jour du nombre de bits à allouer :

  $N_b$= $N_b$- *min(cnt(iexp), $N_b$)*

S25 : Test pour vérifier si tous les bits ont été alloués ($N_b$=0).

  Si $N_b$ >0, décrémentation de 1 de l'index d'exposant: *iexp=iexp*-1 et passage à l'itération suivante en allant à l'étape S22.
  Sinon ($N_b$=0 : tous les bits ont été alloués) et le calcul de la table d'allocation binaire est terminé.

Ces procédures sont décrites en particulier dans les documents EP-2187387 et EP-2202728.

La table d'allocation binaire, *b(n)*, *n*=0, ..., 39, donne pour chaque échantillon le nombre de bits de poids forts de la couche d'extension. Les codes d'amélioration sont donc extraits, puis séquentiellement multiplexés dans le flux binaire (« bitstream » en anglais) de la couche d'amélioration. Ici, 3 bits suivant les 4 bits de la mantisse sont sauvegardés, au lieu de 2 bits seulement dans le codeur G711 hiérarchique à allocation binaire fixe. Puis, après le calcul de la table d'allocation binaire adaptative, le signal d'extension sur *b* bits (*b*= 0, 1, 2 ou 3) est extrait en ne gardant que les *b* bits de poids fort. Pour cela, selon le nombre *b* de bits alloués, un décalage à droite de 3-*b* bits est effectué.

Par rapport au multiplexage du signal d'amélioration à une allocation binaire fixe, le multiplexage avec allocation binaire adaptive est plus complexe. En effet, si dans le cas d'une allocation binaire fixe à 2 bits d'amélioration par échantillon, la composition du flux binaire de cette couche d'amélioration en octets de 8 bits est simple, ce n'est pas le cas pour une allocation dynamique.

Avec une allocation fixe de 2 bits par échantillon, chacun des 10 octets de la couche d'amélioration est composé par les 2 bits d'amélioration de 4 échantillons consécutifs. Ainsi, les 8 bits ($b_7b_6b_5b_4b_3b_2b_1b_0$) du premier octet sont :

- les 2 bits d'amélioration de l'échantillon 0 ($b_7b_6$),
- suivis des 2 bits d'amélioration de l'échantillon 1 ($b_5b_4$),
- puis des 2 bits d'amélioration de l'échantillon 2 ($b_3b_2$),
- et enfin des 2 bits d'amélioration de l'échantillon 3 ($b_1b_0$).

Plus généralement, les 8 bits ($b_7b_6b_5b_4b_3b_2b_1b_0$) du $i^{ieme}$ octet ($i$=0, ...9) sont :

- les 2 bits d'amélioration de l'échantillon $4i$ ($b_7b_6$),
- suivis des 2 bits d'amélioration de l'échantillon $4i$+1 ($b_5b_4$),
- puis des 2 bits d'amélioration de l'échantillon $4i$+2 ($b_3b_2$),
- et enfin des 2 bits d'amélioration de l'échantillon $4i$+3 ($b_1b_0$).

Au décodage, la table d'allocation binaire est reconstruite selon le même principe décrit ci-dessus, les valeurs d'exposant étant disponibles à l'encodeur et au décodeur. Puis, le signal d'amélioration est reconstruit à partir du train binaire de la couche d'amélioration qui utilise la table d'allocation binaire.

Toutefois, il apparaît des inconvénients propres au codage/décodage actuel de la couche d'amélioration de la bande basse du codeur G.711.1.

Par rapport à une allocation fixe (typiquement de 2 bits par échantillon), l'allocation binaire dynamique permet d'allouer un nombre de bits d'amélioration dépendant des amplitudes des échantillons à coder. Cependant cette allocation adaptative est nettement plus complexe qu'une allocation fixe. Elle nécessite plus de mémoire vive et aussi plus de calculs, sans compter le nombre d'instructions à stocker en mémoire morte.

Par exemple dans le cas d'un codec G.711.1 où 80 bits sont alloués à 40 échantillons et le nombre de bits alloués varie de 0 à 3 bits, une allocation binaire dynamique, par rapport à une allocation binaire fixe, nécessite de stocker les tableaux suivants :

- Tableau de l'allocation binaire: 40 mots de 16 bits
- Tableau de la carte des exposants: 400 (=10x40) mots de 16 bits
- Tableau des compteurs d'exposants: 10 mots de 16 bits

Ainsi, par rapport à une allocation fixe dans le cas du G.711.1, l'allocation dynamique nécessite de l'ordre de 450 mots de mémoire.

Concernant la complexité de calcul, le calcul de la carte d'exposants et de la table associée des compteurs d'exposants, ainsi que la procédure itérative d'allocation binaire dynamique, requièrent des adressages complexes, de nombreux accès mémoire et des tests.

La mise à zéro initiale de la table de compteurs d'exposants nécessite par exemple 10 accès mémoire, puis, une boucle sur 40 échantillons est effectuée, comme suit :

a) accès mémoire pour obtenir *iexpn* l'exposant de l'échantillon *n*

b) adressage dans la carte des exposants pour pointer à l'adresse *adr_map* de *map*(*iexpn*,0)

c) adressage dans la table de compteurs pour pointer à l'adresse *adr_cnt* de *cnt*(*iexpn*): *ndr_cnt* = *cnt+iexpn*

d) puis une boucle sur 3 index (*i*= 0, 1,2) est effectuée

    i. lecture (accès mémoire) de la valeur stockée en mémoire à l'adresse *adr_cnt*: *\*ndr_cnt*

    ii. adressage dans la carte des exposants pour pointer à l'adresse *adr_mapi* de *map*(*iexpn*, *\*adr_cnt*): *adr_mapi* = *adr_map* + *\*adr_cnt*

    iii. écriture (stockage) à cette adresse de *n* : *\*adr_mpi* = *n*

    iv. incrément de 1 de la valeur de compteur d'exposants contenue à l'adresse *ndr_cnt*: *\*ndr_cnt* = *\*ndr_cnt*+1

    v. incrément de 1 de l'adresse *ndr_cnt*: *ndr_cnt*++

    vi. incrément de 40 de l'adresse *adr_map*: *adr_map* = *adr_map* +40

Les opérations a), b), c) et d) sont effectuées 40 fois; les opérations dans la boucle interne d) (opérations i à vi) sont effectuées 120 (=40*3) fois.

Si la complexité d'un adressage régulier (avec un incrément constant comme dans les opérations v et vi) est considérée comme négligeable, tel n'est pas le cas pour certaines opérations d'adressage moins régulières. Si l'adressage dans le tableau *cnt* est peu coûteux (addition de l'étape c)), l'adressage dans la table de la carte d'exposants est relativement complexe.

En particulier, pointer à l'adresse d'un élément *map(j,n)* dans un tableau à deux dimensions (10 et 40) nécessite de calculer $40j+n$. Si l'addition de *n* a un poids de « 1 », la multiplication par 40 coûte « 3 ». Pour réduire le coût de cet adressage, il est possible de stocker les adresses partielles, mais alors au détriment d'une augmentation de la taille de la mémoire vive.

Le calcul de la table d'allocation binaire est aussi complexe, en ce que, déjà l'initialisation à zéro de la table d'allocation binaire et à 80 du nombre de bits à allouer nécessite 41 accès mémoire. Les adressages dans les tables de compteurs d'exposant et dans la carte des exposants sont aussi initialisés pour pointer respectivement aux adresses *ndr_cnt* de *cnt*(9) et *adr_map* de *map*(9,0) (*adr_cnt=cnt*+9, *adr_map= map*+40*9).

Puis, une boucle sur 10 valeurs d'index d'exposant (*iexp* allant en décrémentant de 9 à 0) exécute les opérations suivantes :

e) Test pour déterminer si le nombre de bits restants à allouer $N_b$ est plus petit que la valeur courante du compteur d'exposants, *ndr_cnt (=cnt(iexp)*);

- si oui, la variable $N_b$ est stockée dans la variable *bit_cnt*;
- sinon, c'est la valeur *ndr_cnt qui est stockée.

Ce stockage est compté comme un accès mémoire.

f) Initialisation de l'adressage dans la carte des exposants pour pointer à l'adresse *adr_mapi* de *map*(*iexp*, 0): *adr_mapi = adr_map*

g) puis une boucle sur *bit_cnt* indices (*i*= 0, 1, *bit_cnt*-1) est effectuée pour incrémenter de 1 bit l'allocation binaire de chacun des *bit_cnt* premiers échantillons dont les indices sont stockés de *map*(*iexp*,0) à *map*(*iexp, bit_cnt*-1). Dans cette boucle interne, les opérations suivantes sont effectuées:

- lecture (accès mémoire) de l'indice *n* de l'échantillon stocké en mémoire à l'adresse *adr_mapi* (i.e. adresse de l'élément *map*(*iexp*,*i*)): *n= *adr_mapi*
- adressage dans la table d'allocation binaire pour pointer à l'adresse *adt_b* de l'élément *b*(*n*) : *adt_b = b + n*
- incrément de 1 (addition) de l'allocation binaire de l'échantillon *n* et stockage de la valeur incrémentée (accès mémoire): **ndr_b = *ndr_b* +1 (*b*(*n*) = *b*(*n*)+1)
- incrément de 1 de l'adresse dans la carte des exposants : *adr_mapi*++ ( *adr_mapi* pointe maintenant à l'adresse de l'élément *map*(*iexp*,*i*+1)

h) Mise à jour du nombre de bits restant à allouer (soustraction): $N_b = N_b - bit\_cnt$

i) Test pour déterminer si tous les bits ont été alloués:

- Si oui ($N_b$ =0), sortir de la boucle sur *iexp* : l'allocation binaire est terminée
- Sinon ($N_b > 0$), décrémenter de 40 de l'adresse *adr_map*: *adr_map = adr_map*- 40 pour pointer sur l'adresse de l'élément *map*(*iexp*-1, 0) et effectuer les étapes e) à i) pour l'exposant suivant (*iexp= iexp*-1).

Le nombre de fois où est effectuée la boucle externe (opérations e à i) dépend de la carte des exposants (et donc de la distribution des exposants des échantillons à coder). La variabilité de ce nombre rend la boucle plus complexe. Si le nombre de répétitions d'une boucle n'est pas connue avant d'entrer la boucle, il est nécessaire à la fin de chaque itération de faire un test (étape i). Le nombre de fois où les opérations de la boucle interne sont menées est égal au nombre total de bits à allouer (80 dans le cas du G.711.1). En particulier, on retiendra que ces opérations consistent à allouer 1 bit à la fois.

Concernant le multiplexage, comme mentionné précédemment, avec une allocation binaire adaptative, le multiplexage des bits de la couche d'amélioration dans le flux binaire est bien plus complexe qu'avec une allocation binaire fixe.

Avec une allocation dynamique, la composition du flux binaire n'est pas régulière : le nombre d'échantillons dont les bits composent un octet varie, et les bits d'amélioration d'un même échantillon peuvent être sur des octets différents. Par rapport à un multiplexage fixe, le multiplexage adaptatif est bien plus complexe et nécessite dans l'exemple précité 40 tests de boucle (de type « IF ») et 80 additions/soustractions supplémentaires. La composition finale des 10 octets requiert aussi 20 soustractions et 20 décalages binaires.

Ainsi, quand bien même la technique du codage G.711 a été améliorée en qualité par l'introduction d'une extension hiérarchique avec allocation dynamique de bits, cette allocation dynamique requiert un nombre important d'opérations et bien plus de mémoire. Or, un objectif de la standardisation UIT-T de l'extension hiérarchique à G.711 est de parvenir à une faible complexité.

La présente invention vient améliorer la situation.

Elle propose à cet effet un procédé d'allocation binaire dans un codage/décodage hiérarchique comportant un codage/décodage d'une couche d'amélioration d'un signal audionumérique. Le signal audionumérique comporte une succession de $L$ échantillons, dans laquelle chaque échantillon se présente sous la forme d'une mantisse et un exposant. Le procédé comporte en particulier l'allocation d'un nombre prédéterminé $N_b$ de bits d'amélioration à une partie au moins des $L$ échantillons de valeurs d'exposant les plus élevées.

Le procédé comporte les étapes :

a) dénombrer les exposants des $L$ échantillons ayant chacun une valeur donnée,

b) calculer au moins un cumul de dénombrements d'exposants par valeurs décroissantes d'exposant jusqu'à approcher par excès le nombre prédéterminé $N_b$, pour

c) déterminer une valeur seuil de plus grand exposant (noté ci-après « $iexp_0$ ») d'échantillon pour lequel plus aucun bit d'amélioration n'est disponible.

On peut procéder ensuite à l'allocation-même des $N_b$ bits d'amélioration, selon des règles choisies, aux échantillons dont l'exposant est alors supérieur à la valeur seuil $iexp_0$.

Comme on le verra dans les exemples de réalisation décrits ci-après en référence aux figures, cette détermination de la variable $iexp_0$ par décrémentation du nombre de bits disponibles pour l'allocation permet de limiter considérablement la complexité du calcul de l'allocation binaire, par rapport à l'art antérieur présenté ci-avant.

Dans une réalisation, selon les règles choisies précitées, on peut prévoir un nombre maximum $N_a$ de bits à allouer pour un échantillon, et on réserve :

- $N_a$ bits pour une allocation à chaque échantillon dont l'exposant est supérieur à une somme de la valeur seuil $iexp_0$ et du nombre maximum $N_a$,
- aucun bit pour des échantillons dont l'exposant est inférieur ou égal à ladite valeur seuil $iexp_0$, et
- un nombre de bits complémentaires parmi le nombre $N_b$ de bits, pour une allocation aux échantillons dont l'exposant est compris entre la valeur seuil $iexp_0$ plus un et la somme de la valeur seuil et du nombre maximum $N_a$.

On assure ainsi une allocation binaire perfectionnée, basée sur les valeurs d'exposant des échantillons.

Dans un mode de réalisation particulier, on peut décider d'allouer à chaque échantillon dont l'exposant est compris entre la valeur seuil plus un et la somme de la valeur seuil et du nombre maximum $N_a$ :

- la différence entre l'exposant d'un échantillon et la valeur seuil $iexp_0$,
- ou cette différence moins un, selon un critère choisi, comme par exemple un ordre de position de l'échantillon dans la succession d'échantillons.

Néanmoins, pour cette catégorie d'échantillons, des variantes d'allocation sont possibles (par exemple, la prise en compte d'un voisinage d'échantillons, ou tout autre critère).

Par exemple, on peut aussi, plutôt que favoriser les premiers échantillons dont l'exposant est dans l'intervalle [$iexpn0+1$, $iexp0+Na$], favoriser les échantillons dont l'exposant est le plus élevé.

Dans le cas où le nombre $Na$ est prédéterminé, on peut considérer que les échantillons dont l'exposant est strictement supérieur à $iexp0+Na$ peuvent recevoir finalement $Na$ bits.

Toutefois, dans un exemple de réalisation, le nombre $Na$ peut ne pas être prédéfini, *a priori*. Par exemple, le nombre $Na$ peut être déterminé seulement à la fin de l'étape b) ci-dessus (intrinsèquement en fin de cumul) et la mise en oeuvre de l'étape b) permettrait de connaître simplement alors ce nombre $Na$. En effet, on peut ne pas prévoir nécessairement de contrainte sur le nombre $Na$, pour vérifier que l'allocation ne dépasse pas le nombre $Nb$.

D'une manière générale, on comprendra alors que le nombre de bits complémentaires correspond finalement au nombre total de bits à allouer $Nb$, moins le nombre de bits qui est alloué aux échantillons dont l'exposant est strictement supérieur à $iexp0+Na$ (le nombre de tels échantillons pouvant être nul). En revanche, c'est la détermination du seuil $iexp0$ précité qui permet bien d'assurer que cette allocation ne dépasse pas le nombre $Nb$. L'allocation de $Na$ bits à tous les échantillons dont l'exposant est supérieur $iexp0+Na$ ne peut donc pas faire « déborder » l'allocation puisque le seuil $iexp0$ est calculé pour éviter le dépassement du nombre $Nb$ de bits alloués.

Dans une réalisation, l'étape b) par exemple peut comporter :

b1) une détermination d'une plus grande valeur d'exposant (notée ci-après « $iexp_{max}$ ») parmi les $L$ échantillons ;
b2) un cumul des nombres d'exposants depuis la plus grande valeur d'exposant jusqu'à la plus grande valeur

décrémentée $N_a$ fois ; et

b3) une boucle conditionnelle telle que :

■ si le cumul reste inférieur au nombre total de bits $N_b$ à allouer aux *L* échantillons, ce cumul est ajouté à un nouveau cumul calculé par la mise en oeuvre de l'opération b2) avec une décrémentation de un de la plus grande valeur d'exposant, le résultat de cette décrémentation étant pris pour la mise en oeuvre de l'opération b2) en tant que plus grande valeur d'exposant, avec une itération en boucle de l'opération b2) tant que ledit cumul résultant de l'opération b2) reste inférieur au nombre $N_b$,

■ sinon, on calcule un nombre de bits complémentaires restants à une itération immédiatement précédente de l'opération b2), pour déterminer un nombre (L") d'échantillons dont l'exposant est compris entre la valeur seuil plus un et la somme de la valeur seuil et du nombre maximum $N_a$.

Dans une réalisation, l'allocation binaire aux *L* échantillons peut être effectuée par l'exécution de deux boucles :

- une première boucle jusqu'à ce que l'allocation binaire à des échantillons ayant un exposant compris entre la valeur seuil plus un et la somme de la valeur seuil et du nombre maximum $N_a$ soit effectuée, un nombre d'itérations de la première boucle étant compté,
- puis, une deuxième boucle pour effectuer l'allocation binaire des derniers échantillons restants, itérée un nombre de fois qui est fonction dudit nombre d'itérations de la première boucle.

Dans une réalisation, un tableau de compteurs d'exposants peut être établi à l'étape a) et un pointeur d'adresse dans le tableau est avantageusement décrémenté dans une boucle conditionnelle pour la mise en oeuvre de l'étape b).

Ainsi, la détermination de la plus grande valeur d'exposant ($iexp_{max}$) parmi les *L* échantillons peut être effectuée efficacement par lecture du tableau précité.

Au codage notamment, le procédé peut comporter classiquement la composition d'un train binaire d'un signal d'amélioration résultant du codage de la couche d'amélioration. Dans un mode de réalisation présenté et commenté en Annexe 2 ci-après, cette composition est avantageusement effectuée à la volée après allocation binaire de chaque échantillon.

Dans une variante selon le mode de réalisation présenté en Annexe 1 (appelé « premier mode de réalisation » ci-après), les données d'allocation binaire sont stockées d'abord dans une table, et la composition du train binaire est effectuée sur la base de cette table.

Le procédé s'applique avantageusement au codage/décodage par quantification de type MIC (à Modulation par Impulsion et Codage) selon la loi de codage logarithmique de compression d'amplitude de type A ou de type $\mu$, conforme à la recommandation ITU-T G.711.1.

L'invention trouve une application avantageuse (mais non limitative, bien entendu) au traitement de signal par décodage au moins partiel, mixage et ré-encodage au moins partiel de flux binaires entrants, dans une architecture de pont, notamment audio, de téléconférence entre plusieurs terminaux. Dans une telle application, la mise en oeuvre du deuxième mode de réalisation en particulier est avantageuse, comme on le verra plus loin.

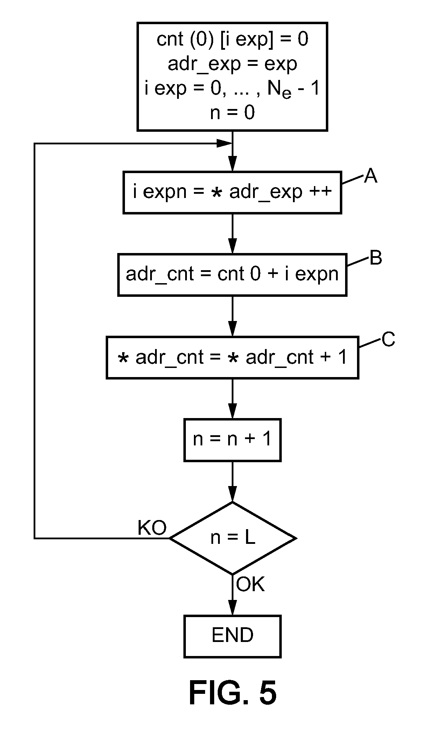

La présente invention peut être mise en oeuvre par exécution d'un programme informatique comportant des instructions pour la mise en oeuvre du procédé ci-avant lorsqu'elles sont exécutées par un processeur et l'invention vise, à ce titre, un tel programme, dont des exemples d'organigrammes sont illustrés sur les figures 5 à 9 commentées ci-après.

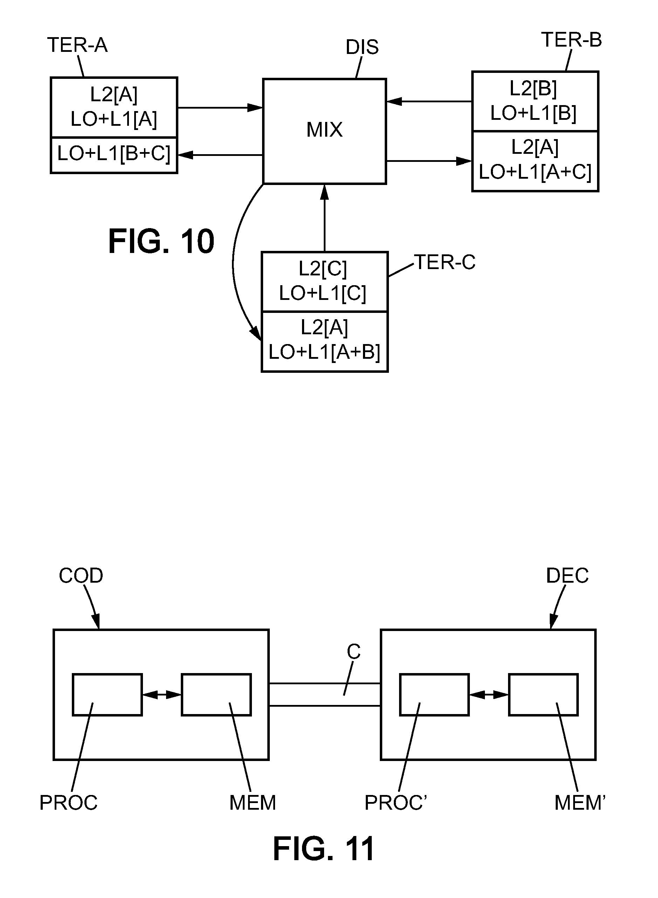

Comme présenté en référence à la figure 11, la présente invention vise aussi un dispositif codeur COD d'une couche d'amélioration dans un codage hiérarchique d'un signal audionumérique, et comportant des moyens informatiques (comme un processeur PROC et une mémoire MEM typiquement) pour la mise en oeuvre du procédé de codage au sens de l'invention et/ou de son application précitée.

Elle vise aussi un dispositif décodeur DEC d'une couche d'amélioration dans un décodage hiérarchique d'un signal audionumérique, et comportant des moyens informatiques (comme un processeur PROC' et une mémoire MEM') pour la mise en oeuvre du procédé de décodage au sens de l'invention et/ou de son application précitée. Le décodeur et le codeur précité peuvent être reliés entre eux par un canal C.

Ainsi, la présente invention, basée sur la technologie d'extension hiérarchique avec allocation binaire dynamique, permet de réduire la mémoire vive et le nombre de calculs tout en conservant la qualité obtenue. Dans un mode de réalisation présenté en particulier en Annexe 1, les signaux obtenus sont, en tout point, compatibles avec ceux de l'état de l'art. Il en résulte une facilité de mise en oeuvre (gain en mémoire et en puissance de calcul) et par voie de conséquence un gain économique. L'invention est en particulier très utile pour le codage dans les systèmes de téléconférence.

Au lieu d'effectuer l'allocation binaire 1 bit par 1 bit, l'invention détermine directement pour chaque échantillon le nombre total de bits d'amélioration à lui allouer en fonction de son exposant. Avantageusement, l'invention n'utilise pas de carte d'exposants, ce qui réduit la mémoire vive et supprime de plus de nombreux accès mémoires et des opérations d'adressage complexes. L'invention détermine le plus grand exposant $iexp_{max}$ des exposants de $L$ échantillons et le plus grand exposant $iexp_0$ des échantillons qui ne reçoivent pas de bit d'amélioration. Puis, à partir de ces deux exposants, le nombre total de bits à allouer à chaque échantillon est calculé.

Dans un mode de réalisation, l'application de l'invention permet d'effectuer une allocation binaire dynamique identique à la procédure itérative 1 bit par 1 bit utilisée initialement dans le codage/décodage G.711.1 de l'état de la technique.

D'autres avantages et caractéristiques de l'invention apparaîtront à la lecture de la description d'exemples de réalisation présentés ci-après en référence aux dessins, sur lesquels :

- la figure 1 illustre un exemple général de système pour la mise en oeuvre du procédé, avec un codeur 11 et un décodeur 14 dans un contexte de l'invention,
- la figure 2 détaille schématiquement la structure d'un codeur hiérarchique pour la mise en oeuvre de l'invention,
- la figure 3 illustre le calcul d'une carte d'exposants et d'une table de compteurs d'index d'exposants au sens de l'art antérieur,
- la figure 4 illustre le calcul d'une table d'allocation binaire au sens de l'art antérieur,
- la figure 5 illustre un exemple d'organigramme pour la construction d'un tableau de compteurs d'exposants, dans une première étape selon un mode de réalisation de l'invention,
- la figure 6 illustre un exemple d'organigramme pour le calcul d'un cumul des compteurs d'exposants, selon une étape générale suivante, au sens de l'invention,
- la figure 7 illustre un exemple d'organigramme pour le calcul de la variable $iexp_0$ correspondant au plus grand exposant des échantillons qui ne recevront pas de bit d'amélioration,
- la figure 8A illustre un exemple d'organigramme de procédure d'une allocation binaire selon un mode de réalisation,
- la figure 8B illustre un exemple d'organigramme de procédure d'une allocation binaire selon une variante de réalisation,
- la figure 9 résume un exemple d'organigramme général du dénombrement de bits à allouer aux $L$ échantillons d'une trame, et
- la figure 10 illustre schématiquement l'application de l'invention à un pont de téléconférence entre plusieurs terminaux,
- la figure 11 illustre un système de type codeur/décodeur pour une mise en oeuvre de l'invention.

Une application possible de l'invention concerne le codage d'une couche d'amélioration dans un codage hiérarchique. Ce codage hiérarchique comprend le codage d'une couche de base par quantification, selon une loi de compression d'amplitude, d'une succession de $L$ échantillons d'un signal numérique S (référence de la figure 2). Les échantillons sont codés sur un nombre prédéterminé de bits comprenant des bits d'exposant et des bits de mantisse, pour obtenir un premier bloc binaire d'indices de quantification ($I_{MIC}$), un nombre prédéterminé de bits de mantisse de poids faible n'étant pas pris en compte dans le premier bloc. En particulier, le codage de la couche d'amélioration vise à retenir dans un deuxième bloc binaire les bits de poids le plus fort parmi les bits qui ne sont pas pris en compte dans le premier bloc, pour délivrer ainsi dans ce deuxième bloc des informations additionnelles de mantisse pour une partie au moins des $L$ échantillons précités. Le codage de la couche d'amélioration comporte typiquement un calcul du nombre de bits et leur allocation à ces échantillons pour fournir dans la couche d'amélioration les informations additionnelles de mantisse pour ces échantillons parmi les $L$ échantillons, en fonction de l'exposant de chacun des $L$ échantillons.

Ainsi, dans l'exemple décrit, on cherche à allouer un total de $N_b$ bits additionnels à $L$ échantillons au maximum, selon les valeurs d'exposant des $L$ échantillons, pour améliorer le codage des échantillons dans la couche d'amélioration (couche « 1 » (L1)) du codage hiérarchique (mené par le module 23 de la figure 2).

On dénomme ci-après:

- $N_a$ le nombre maximum de bits additionnels à allouer pour un échantillon,
- $N_e$ le nombre total de valeurs d'exposants et
- $exp[L]$ le tableau contenant les exposants des $L$ échantillons.

L'allocation binaire est générée en utilisant les exposants des $L$ échantillons, $exp(n)$, avec $n=0, ..., L-1$ ($0 \leq exp(n) < N_e$).

Dans une première phase, les exposants sont dénombrés, puis dans une deuxième phase, l'allocation binaire des $L$ échantillons est calculée.

Plus particulièrement, dans un mode de réalisation ci-après, dans la première phase précitée :

- on compte le nombre d'exposants ayant une valeur donnée,

- on stocke ces compteurs dans un tableau *cnt0*[$N_e$] (selon les étapes A) à C) décrites ci-dessous),
- puis, on calcule un tableau de cumuls de compteurs d'exposants *cnt-cum*[$N_e+N_a$-1].

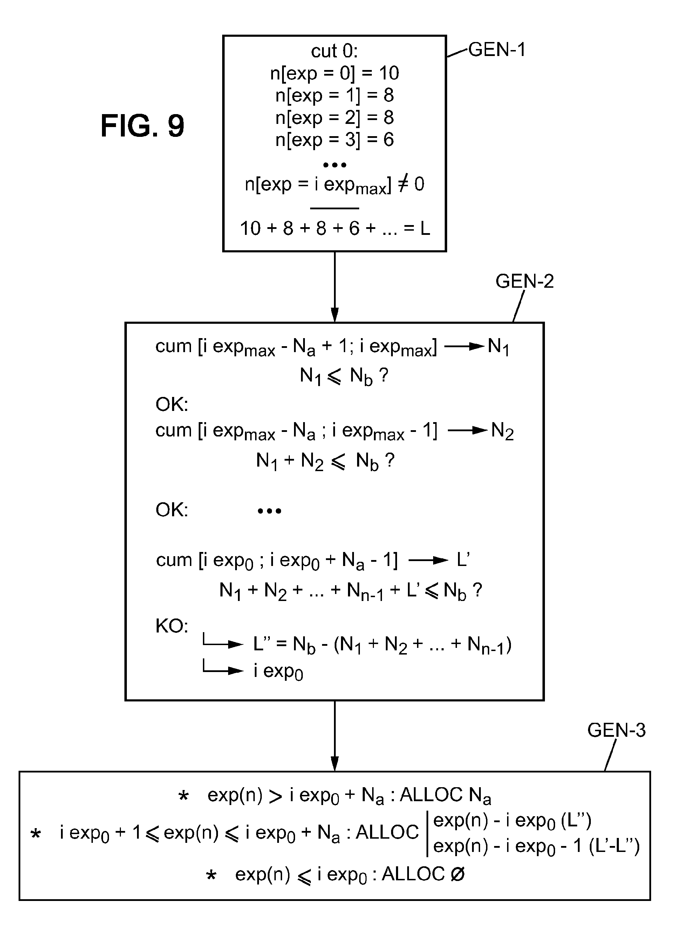

On a représenté sur la figure 9 les étapes générales du procédé d'encodage de la couche d'amélioration dans un exemple de réalisation. Dans une première étape générale GEN-1, on construit le tableau des compteurs d'exposants *cnt0*. Dans l'exemple illustré, sur les *L* échantillon d'un bloc (ou trame) du signal d'origine S(z) (avec par exemple *L*=40) :

- le nombre d'échantillons dont l'exposant est à 0 est : 10,
- le nombre d'échantillons dont l'exposant est à 1 est : 8,
- le nombre d'échantillons dont l'exposant est à 2 est : 8,
- le nombre d'échantillons dont l'exposant est à 3 est : 6,
- etc.
- jusqu'à atteindre une valeur d'exposant ($iexp_{max}$+1) pour laquelle il ne reste plus d'échantillon.

Ainsi, la valeur d'exposant notée $iexp_{max}$ est la plus grande valeur d'exposant pour laquelle il reste encore au moins un échantillon dont l'exposant vaut $iexp_{max}$.
Bien entendu, la somme de ces nombres vaut le nombre *L* d'échantillons dans une trame.
On note $N_a$ le nombre de bits additionnels maximum qui peuvent être alloués à un échantillon (par exemple $N_a$=3). On recherche ensuite la valeur $iexp_0$, définie comme étant le plus grand exposant des échantillons qui ne recevront pas de bit d'amélioration : l'allocation binaire des échantillons dont l'exposant est inférieur ou égal à $iexp_0$ est alors de 0 bit.
Ainsi, dans une deuxième étape générale GEN-2, on estime, parmi les $N_b$ bits à allouer au total, le nombre de bits à réserver pour l'allocation future aux échantillons dont l'exposant est compris entre $iexp_{max}$ et $iexp_{max}$-$N_a$+1 (en rappelant que l'un de ces échantillons ne peut se faire allouer, au maximum, que $N_a$ bits d'amélioration).
Ensuite, on décrémente la valeur d'exposant à considérer et on estime le nombre de bits, parmi les bits restant après la première incrémentation de l'étape GEN-2, qui resteraient à allouer aux échantillons dont l'exposant est compris entre $iexp_{max}$-1 et $iex_{pmax}$-$N_a$. Ici encore, $N_a$ bits d'amélioration au maximum pourront ultérieurement être alloués à chaque échantillon si bien entendu il reste autant de bits à pouvoir allouer parmi les $N_b$' bits complémentaires après la première incrémentation précitée.
On poursuit cette décrémentation jusqu'à atteindre une population d'échantillons dont l'exposant est compris entre $iexp_0$ et $iexp_0+N_a$-1 et pour lesquels le nombre de bits restants $N_b$' n'est plus suffisant pour satisfaire l'allocation de $N_a$ bits au maximum à chacun de ces échantillons. Ainsi, le nombre *L'* de la figure 9 représente le nombre de bits comptés pour une implémentation de trop de la décrémentation précitée. Ce nombre *L'* correspond aussi au nombre d'échantillons dont l'exposant est compris entre $iexp_0$ et $iexp_0+N_a$-1 et il est donné par le cumul des exposants *cnt_cum*[$iexp_0+N_a$-1] pour lesquels une allocation de (*exp(n)-iexp_0*) bits par échantillon n'est pas assurée. Parmi ces *L'* échantillons, le nombre *L"* est relatif aux échantillons pour lesquels une allocation de (*exp(n)-iexp_0*) bits par échantillon est possible.
Ainsi, les échantillons dont l'exposant est supérieur à $iexp_0+N_a$, se verront allouer $N_a$ bits chacun, lors d'une étape d'allocation binaire ultérieure GEN-3, mais pour les échantillons dont l'exposant *exp(n)* est compris dans l'intervalle [$iexp_0$+1, $iexp_0+N_a$], l'allocation pourra être *exp(n)-iexp_0* (pour *L"* échantillons) ou *exp(n)-iexp_0*-1 (pour les *L'-L"* échantillons restants). Comme mentionné précédemment, pour cette catégorie d'échantillons, des variantes d'allocation sont possibles. Dans un mode de réalisation particulier, l'allocation se fait simplement selon leur ordre « d'apparition » dans la trame de *L* échantillons. Les échantillons les premiers traités parmi ces échantillons restants seront alors les premiers servis lors de l'allocation de bits d'amélioration. Enfin, les échantillons dont l'exposant est inférieur ou égal à la valeur seuil $iexp_0$ ne bénéficient d'aucun bit supplémentaire.
Ainsi, la première étape générale GEN-1 consiste à construire le tableau de compteurs d'exposants, comme décrit en détail ci-après, à titre d'exemple de réalisation, en référence à la figure 5.
Le tableau de compteurs *cnt0* est d'abord initialisé à zéro (avec $N_e$ accès mémoires): *cnt0*[*iexp*] = 0, pour 0≤*iexp*<$N_e$.
Un pointeur *adr_exp* dans la table des exposants est aussi initialisé à l'adresse de *exp(0)*: *adr_exp=exp*.
Puis, dans une boucle sur les *L* échantillons (0≤*n*<*L*), les opérations suivantes sont effectuées :

A) accès mémoire pour obtenir *iexpn* l'exposant de l'échantillon *n* (et incrément de 1 de pointeur adr_exp pour pointer à l'adresse de l'exposant de l'échantillon suivant): *iexpn* = *adr_exp*++
B) adressage dans la table de compteurs pour pointer à l'adresse *adr_cnt* de *cnt0*(*iexpn*): *adr_cnt* = *cnt0*+*iexpn*
C) incrément de 1 (addition) de la valeur de compteur d'exposants contenue à l'adresse *adr_cnt*: *adr_cnt* = *adr_cnt*+1

Les opérations A), B), C) sont effectuées *L* fois. Par rapport à la méthode de l'art antérieur décrite précédemment, on ne retrouve pas de boucle interne, ni de coûteux adressages d'un tableau à deux dimensions.

Une fois calculé le tableau *cnt0*, on calcule le tableau *cnt_cum*[$N_e$+$N_a$-1] du cumul des compteurs d'exposants:

$$cnt\_cum[j] = \sum_{i=\max(0,\,j-(N_e-1))}^{\min(j,N_a-1)} cnt0[j-i], \; 0{\leq}j{<}N_e{+}N_a{-}1$$

Cette expression se distingue en pratique en trois cas, selon les bornes de la sommation:

$$cnt\_cum[j] = \sum_{i=0}^{j} cnt0[j-i], \; 0{\leq}j{<}N_a$$

$$cnt\_cum[j] = \sum_{i=0}^{N_a-1} cnt0[j-i], \; N_a{\leq}j{<}N_e$$

$$cnt\_cum[j] = \sum_{i=j-(N_e-1)}^{N_a-1} cnt0[j-i], \; N_e{\leq}j{<}N_e{+}N_a{-}1$$

On pourrait effectuer trois boucles correspondant aux trois cas. Toutefois, dans une variante avantageuse permettant de limiter le nombre d'instructions (à mémoriser en mémoire programme PROM) et d'avoir ainsi une taille de mémoire programme raisonnable, on peut préférer avoir un tableau de compteurs d'exposants *cnt0_a* de taille $N_e$+$2N_a$ (avec donc une augmentation de $2N_a$ mots seulement). L'étape d'initialisation à zéro comporte alors $2N_a$ accès mémoire supplémentaires et la définition d'un pointeur cnt0 qui pointe à l'adresse *cnt0_a*+$N_a$. Les étapes A) à C) restent les mêmes. Avec ce tableau de taille légèrement augmentée, le calcul du tableau du cumul des compteurs d'exposants se présente ainsi :

- un pointeur *adr_cnt0* sur le tableau des compteurs d'exposants est initialisé à *cnt0* (=*cnt0_a*+ +$N_a$), donc à l'adresse de *cnt0*(0) (*cnt0*(0) étant alors le nombre d'échantillons ayant 0 comme exposant), et
- un deuxième pointeur *adr_cnt_cun* est initialisé à l'adresse de *cnt_cum*(0) (*adr_cnt_cum*=*cn_cum*).

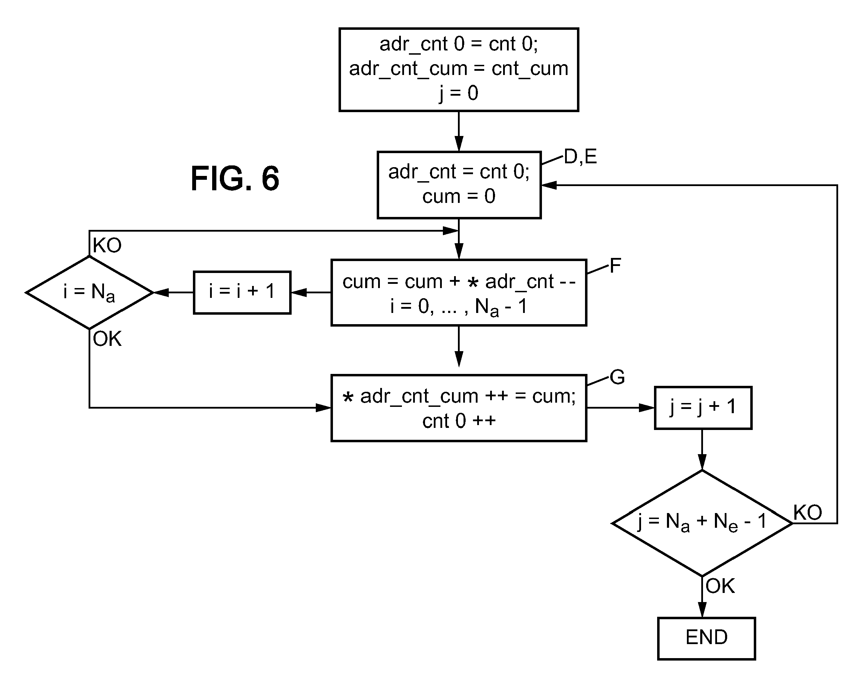

Puis, dans une boucle sur les $N_e$+$N_a$ cumuls ($0{\leq}$j$< N_e$+$N_a$-1), les opérations suivantes sont effectuées, en référence à la figure 6 :

D) initialisation d'un deuxième pointeur *adr_cnt* sur le tableau *cnt0_a* : *adr_cnt*=*cnt0*
E) initialisation de la variable *cum* à zéro: *cum* = 0
F) boucle pour cumuler les $N_a$ compteurs ($0{\leq}i{<}N_a$):

- à chaque itération de cette boucle la valeur du compteur à l'adresse courante *adr_cnt* est additionnée à la variable *cum* puis l'adresse *adr_cnt* est décrémentée de 1: *cum* = *cum* + *\*adr_cnt--.*

G) en sortie de la boucle interne F), la variable *cum* est stockée à l'adresse *adr_cnt_cum*, et les deux pointeurs *adr_cnt_cum* et *cnt0* sont post-incrémentés de 1:

- *\*adr_cnt_cum*++ = *cum* et *cnt0*++.

Des variantes peuvent être prévues pour calculer efficacement ce tableau de cumuls.
Par exemple, au lieu d'initialiser à zéro la variable *cum* et d'effectuer la boucle interne F) $N_a$ fois, on peut l'effectuer une fois de moins ($0{\leq}i{<}N_a$-1), en initialisant à l'étape E) la variable *cum* avec la valeur du compteur à l'adresse *adr_cnt* suivi du décrément de 1 ce pointeur: *cum* = *\*adr_cnt--.*
De même, on peut séparer le calcul des $N_a$ premiers cumuls des $N_e$ derniers en effectuant donc deux boucles :

- avec une initialisation de la variable *cum* à 0, puis sur $N_a$ itérations ($0{\leq}$j$<N_a$), additionner la valeur du compteur à l'adresse courante *cnt0* à la variable *cum* en stockant la variable *cum* à l'adresse *adr_cnt_cum*, les deux pointeurs

adr_cnt_cum et cnt0 étant tous deux post-incrémentés de 1: cum += *cnt0++ et *adr_cnt_cum++ = cum ;

- avec une seconde boucle (sur j, avec $N_a \leq j < N_e + N_a$-1) similaire à la boucle décrite aux étapes D) à G) dans laquelle les pointeurs initiaux adr_cnt_cum et cnt0 sont ceux obtenus en sortie de la première boucle ($0 \leq j < N_a$).

Dans cette variante, on compte moins de calculs et la taille du tableau cnt0_a est de ($N_e + N_a$) correspondant alors à une réduction de $N_a$ mots (le pointeur cnt0 étant alors initialisé à l'adresse du premier élément de cnt0_a: cnt0=cnt0_a), mais la mémoire programme est augmentée par les instructions de la première boucle.

Le tableau de cumuls peut aussi être construit par une relation de récurrence, le cumul à l'itération courante étant obtenu en soustrayant un compteur et en additionnant un compteur au cumul calculé à l'itération précédente, comme suit :

$$cnt\_cum[j+1] = cnt\_cum[j] - cnt0[j - N_a] + cnt0[j+1]$$

On comprendra que selon le compromis recherché entre complexité, taille de mémoire vive, taille de mémoire programme, il est possible de combiner différentes variantes.

Par exemple, on peut combiner les variantes de deux boucles séparées de calcul du tableau de cumuls, d'initialisation du cumul non pas à zéro mais avec la valeur cnt0(0) et d'exploitation de la relation de récurrence. Dans ce cas, la variable cum en sortie de la première boucle sur les $N_a$ premiers cumuls est utilisée pour calculer la première itération de la relation de récurrence dans la seconde boucle de calcul des cumuls.

Le tableau de cumul de compteurs d'exposants obtenu par la technique selon l'invention correspond au tableau de compteurs d'index d'exposants de l'art antérieur, mais son calcul ne nécessite pas la coûteuse carte d'index d'exposants (coûteuse tant en mémoire qu'en complexité).

On décrit maintenant le calcul de la table d'allocation binaire.

Pour éviter la coûteuse allocation binaire bit par bit, le nombre total de bits alloués à un échantillon est alloué en une seule fois. Ce nombre de bits est déterminé en fonction de l'exposant de l'échantillon, du plus grand exposant ($iexp_{max}$) des exposants des $L$ échantillons et du plus grand exposant $iexp_0$ des échantillons qui ne reçoivent pas de bit d'amélioration, étant rappelé que l'allocation binaire des échantillons dont l'exposant est inférieur ou égal à $iexp_0$ est de 0 bit (comme décrit précédemment en référence à l'étape GEN-2 de la figure 9).

Les deux premières étapes consistent donc à rechercher ces deux exposants $iexp_{max}$ et $iexp_0$.

Pour rechercher le plus grand exposant $iexp_{max}$ parmi les exposants des L échantillons, on peut effectuer une boucle sur les $L$ exposants des échantillons pour déterminer le plus grand exposant.

On peut alors donner à titre d'exemple de procédure un pseudo-code utilisant des instructions d'opérateurs de base selon la recommandation ITU-T G. 191 (« Software tools for speech and audio coding standardization », Mars 2010), de telles instructions étant commentées dans le tableau ci-après :

$$ptr\_exp = exp;$$
$$iexp_{max} = 0;$$
$$\text{FOR}(n=0; n<L; n++) \{$$
$$\quad temp = \text{sub}(iexp_{max}, *ptr\_exp);$$
$$\quad \text{if}(temp < 0) \{$$
$$\quad\quad iexp_{max} = *ptr\_exp; \text{move16}();$$
$$\quad \}$$
$$\quad ptr\_exp++;$$
$$\}$$

L'instruction « FOR » par exemple correspond donc à une boucle effectuée L fois ici, avec un nombre de fois connu avant d'entrer dans la boucle. Cette instruction a un poids en complexité de « 4 » pour toute la boucle. Par contre, l'instruction « WHILE » correspond à une boucle conditionnelle (le nombre de fois n'est pas connu avant d'entrer dans la boucle) et l'instruction a un poids en complexité de « 4 » à chaque itération de la boucle. On comprendra alors que l'utilisation de l'instruction « FOR » dans le pseudo-code ci-dessus est plus avantageuse.

De même, dans le pseudo-code ci-dessus, l'instruction « if » (en lettres minuscules) correspond à un test unique suivi d'un seul opérateur de base simple. Dans ce cas, le coût d'un tel test est négligeable. Tel n'est pas le cas d'un test « IF » notamment, quand plusieurs instructions ou une opération complexe (telle qu'un appel de fonction) sont à effectuer conditionnellement en aval du test. L'instruction « IF » (en lettres majuscules) a typiquement un poids de « 4 ». De plus, si ce test n'est pas vérifié (branche « sinon » en sortie du test) il faut effectuer des instructions en aval. L'instruction « ELSE » qui correspond à ce cas a typiquement un poids de « 4 ». Le tableau ci-après résume, pour plusieurs types d'instruction, leurs poids en complexité.

| Instructions | Poids en complexité | Label de l'instruction |
|---|---|---|
| Accès en mémoire (écriture ou lecture) | 1 | move16() |
| Addition/soustraction | 1 | add()/sub() |
| Décalage binaire à gauche/droite (multiplication/division par une puissance de 2) | 1 | shl()/shr() |
| "ou" logique bit à bit | 1 | s_or |
| Comparaison de deux valeurs et sélection de la plus grande/ la plus petite | 1 | s_max()/s_min() |
| Multiplication par une non-puissance de 2 | 3 | i_mult() |
| Test "simple" (suivi d'un seul opérateur de base simple) | 0 | If |
| Test "complexe" (suivi de plusieurs instructions) ou d'un "ELSE" | 4 | IF |
| Test "complexe" avec des instructions si non vérifié | 4 | ELSE |
| Boucle effectuée un nombre de fois N constant | 4 | FOR |
| Boucle effectuée un nombre de fois N variable (sortie de boucle conditionnelle) | 4N | WHILE |

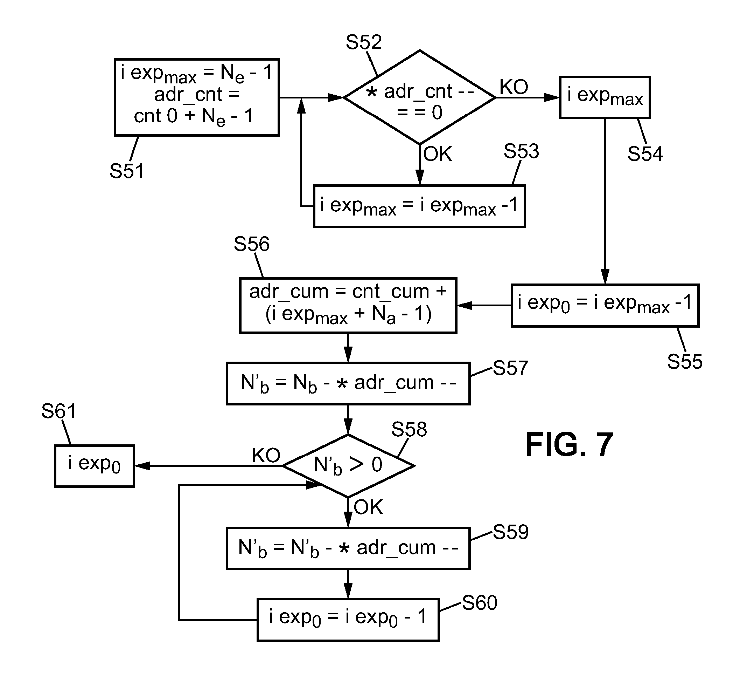

Avantageusement, le nombre d'exposants $N_e$ étant généralement plus petit que le nombre d'échantillons $L$, on préfère chercher dans le tableau des compteurs $cnt0[N_e]$ le dernier élément non nul. En référence à la figure 7, on procède à l'étape S51 à une initialisation de la variable $iexp_{max}$ à $(N_e-1)$, et du pointeur $adr\_cnt$ à l'adresse de l'élément $cnt0[N_e-1]$:

$$iexp_{max}=N_e-1;\ adr\_cnt=cnt0+N_e-1;$$

Ensuite, une boucle conditionnelle de recherche dans le tableau $cnt0[N_e]$ est effectuée, avec un test sur la valeur du compteur à l'adresse $ndr\_cnt$ suivi d'une post-décrémentation de ce pointeur (étape S52) :

- si la valeur testée est nulle, décrémentation de 1 de $iexp_{max}$ (étape S53) et passage à l'itération suivante,
- sinon, sortie de boucle, la valeur $iexp_{max}$ en sortie de boucle est le plus grand exposant parmi tous les exposants des $L$ échantillons (étape S54).

Le pseudo-code correspondant est :

WHILE(*$adr\_cnt$-- == 0) $iexp_{max}$ = sub($iexp_{max}$,1)

L'étape suivante consiste à rechercher le plus grand exposant $iexp_0$ des échantillons ne recevant pas de bit d'amélioration (0 bit). Pour ce faire, en partant d'un exposant $iexp_0$ égal à l'exposant $iexp_{max}-1$ (étape S55), d'un pointeur sur le tableau du cumul de compteurs d'exposants initialisé à l'adresse de $cnt\_cum[iexp_{max}+N_a-1]$ (étape S56), et d'un nombre de bits restant à allouer $N'_b$ égal à « $N_b - cnt\_cum[iexp_{max}+N_a-1]$ » (étape S57), une boucle conditionnelle est effectuée avec un test sur $N'_b$: tant que $N'_b$ est strictement positif ($N'_b >0$ au test S58), la boucle est itérée et $N'_b$ est décrémenté de $cnt\_cum[iexp_0+N_a-1]$ (étape S59), puis $iexp_0$ est décrémenté de 1 (étape S60). Le pseudo-code ci-dessous donne un exemple de la procédure conforme à la représentation de la figure 7 :

$$iexp_0 = \mathrm{sub}(iexp_{max}, 1);$$

$$adr\_cum = cnt\_cum + (iexp_{max} + N_a - 1);$$

$$N'_b = \mathrm{sub}(N_b, {}^*adr\_cum{-}{-});$$

$$\mathrm{WHILE}\ (N'_b > 0)\ \{$$

$$N'_b = \mathrm{sub}(N'_b, {}^*adr\_cum{-}{-});$$

$$iexp_0 = \mathrm{sub}(iexp_0, 1);$$

$$\}$$

Ainsi, à chaque itération $adr\_cum$ pointe à l'adresse de $cnt\_cum[iexp_0 + N_a - 1]$ qui donne le nombre d'échantillons ayant comme exposants $iexp_0 + i$, avec $i = 0, ..., N_a - 1$.

A l'initialisation, $iexp_{max}$ étant le plus grand exposant des L échantillons, $adr\_cum$ pointe à l'adresse $cnt\_cum[iexp_{max} + N_a - 1]$ qui donne donc le nombre d'échantillons ayant comme exposant $iexp_{max}$ (puisqu'aucun échantillon n'a pour exposant $iexp_{max} + 1$, $iexp_{max} + 2$, $iexp_{max} + N_a - 1$).

Puis, à la première itération $adr\_cum$ pointe à l'adresse de $cnt\_cum[(iexp_{max} + N_a - 2)]$ qui donne le nombre d'échantillons ayant comme exposant soit $iexp_{max}$ soit ($iexp_{max} - 1$).

A la dernière itération (en sortie de cette boucle conditionnelle à l'étape S61), l'exposant $iexp_0$ est le plus grand exposant pour lequel les échantillons reçoivent 0 bit (aucun bit n'étant donc alloué aux échantillons dont l'exposant est inférieur ou égal à $iexp_0$).

Il faut noter que $iexp_0$ peut être négatif, auquel cas tous les échantillons se verront allouer au moins un bit.

L'allocation binaire de chaque échantillon dépend alors de la différence entre son exposant et du nombre $iexp_0$. Les échantillons dont l'exposant est égal à $iexp_0 + 1$ recevront 1 ou 0 bit, selon le nombre de bits restant à allouer.

Plus généralement, les échantillons dont l'exposant est égal à $iexp_0 + i$, $1 \leq i \leq N_a$ reçoivent $i$ ou ($i-1$) bits, alors que les échantillons dont l'exposant est strictement supérieur à $iexp_0 + N_a$ recevront $N_a$ bits.

Pour les échantillons dont l'exposant $exp(n)$ est compris dans l'intervalle $[iexp_0 + 1, iexp_0 + N_a]$, l'allocation peut être $exp(n) - iexp_0$ ou $exp(n) - iexp_0 - 1$. Le nombre d'échantillons dont l'exposant se situe dans cet intervalle est donné par le cumul des exposants $cn\_cum[iexp_0 + N_a - 1]$ et correspond finalement au nombre $L'$ présenté ci-avant en référence à la figure 9, soit :

$$L' = cnt\_cum[iexp_0 + N_a - 1]$$

Parmi ces $L'$ échantillons, le nombre $L''$ d'échantillons auxquels est alloué un nombre de bits égal à la valeur de leur exposant diminuée de $iexp_0$ (soit $exp(n) - iexp_0$) est donné par :

$$L'' = N_b - \sum_{j=i\exp_0 + 1}^{i\exp_{max}} cnt\_cum[j + N_a - 1] = N'_b + cnt\_cum[i\exp_0 + N_a - 1] = N'_b + L'$$

(avec $N'_b$ négatif ou nul en sortie KO du test S58).

La présente invention offre une grande flexibilité dans le choix de ces $L''$ échantillons auxquels sont alloués un nombre de bits égal à la valeur de leur exposant diminuée de $iexp_0$. Dans une réalisation, le choix des $L''$ échantillons parmi ces $L'$ échantillons permet d'obtenir une allocation binaire identique à l'allocation bit par bit du G.711.1 telle que décrite dans l'art antérieur. Ce choix consiste à prendre les $L''$ premiers échantillons dont l'exposant est dans l'intervalle précité.

On décrit maintenant le calcul de l'allocation binaire proprement dite.

L'allocation binaire aux $L$ échantillons est effectuée dans l'exemple de réalisation ci-après par l'exécution de deux boucles :

- une première boucle jusqu'à ce que l'allocation binaire aux $L''$ premiers échantillons ayant un exposant dans l'intervalle $[iexp_0 + 1, iexp_0 + N_a]$ soit effectuée,

- puis une deuxième boucle pour effectuer l'allocation binaire des derniers échantillons restants.

Le nombre de fois où la première boucle est effectuée dépend du nombre $L''$, ainsi que de la position de ces $L''$ échantillons parmi les $L$ échantillons. Le nombre de fois où cette boucle doit être effectuée n'est donc pas connu avant d'entrer dans cette boucle. Par contre, le nombre de fois, noté « $N$ », où la deuxième boucle doit être effectuée peut être déterminé avant d'entrer dans cette deuxième boucle à partir du nombre de fois où la première boucle a été effectuée.

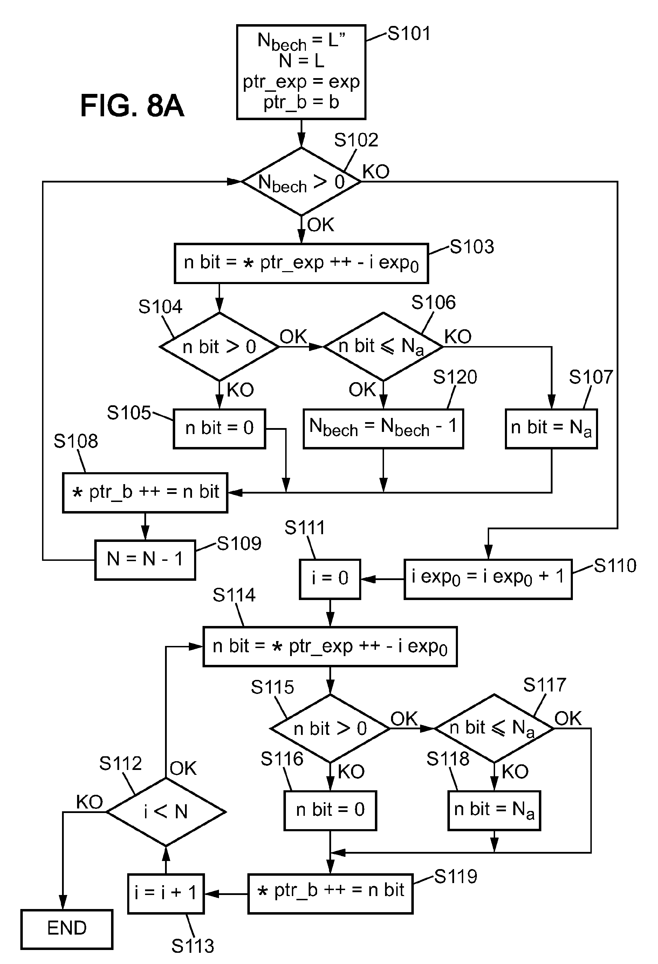

La procédure d'une allocation binaire selon l'invention peut s'effectuer alors, en référence à la figure 8A, en commençant par une étape S101 d'initialisation :

- du compteur d'échantillons $Nbech$ ayant un exposant dans l'intervalle [$iexp_0$+1, $iexp_0$+$N_a$] à $L''$,
- du nombre de fois $N$ où la deuxième boucle doit être effectuée à $L$,
- de deux pointeurs $ptr\_exp$ et $ptr\_b$ pour commencer l'allocation binaire par le premier échantillon, avec :

  ○ $ptr\_exp$ pointant sur le premier élément du tableau d'exposants (&$exp$[0]=$exp$,$exp$[0] étant l'exposant du premier échantillon),
  ○ $ptt\_b$ pointant sur le premier élément du tableau d'allocation binaire (&$b$[0]=$b$,$b$[0] étant l'allocation binaire du premier échantillon).

Dans la première boucle (avec le test S102 portant sur $Nbech$) :

- la différence ($nbit$) entre l'exposant du $n^{ième}$ échantillon et $iexp_0$ est d'abord calculée (étape S103),
- puis, cette différence est bornée à zéro inférieurement (étapes S104 et S105).
- si cette différence est strictement positive (sortie OK du test S104),

  ○ un autre test S106 est effectué pour déterminer si cette différence est inférieure ou égale à $N_a$ :

    ▪ si oui, l'exposant de l'échantillon est dans l'intervalle [$iexp_0$+1, $iexp_0$+$N_a$]) et le compteur $Nbech$ est décrémenté de 1 (étape S120),
    ▪ sinon, la différence est bornée supérieurement par $N_a$ (étape S107)

- $nbit$ est alors l'allocation binaire du $n^{ième}$ échantillon (étape S108), et
- le compteur $N$ est décrémenté de 1 (étape S109).

Tant que $Nbech$ est strictement positif (flèche OK issue du test S102), on passe à l'itération suivante. Sinon ($Nbech$ =0, correspondant à la sortie KO), l'allocation binaire du dernier des $L''$ premiers échantillons ayant leur exposant dans l'intervalle [$iexp_0$+1, $iexp_0$+$N_a$] vient d'être déterminée (étape S108) et on sort de la boucle conditionnelle sur $Nbech$ pour entrer dans la deuxième boucle et effectuer l'allocation binaire des $N$ derniers échantillons.

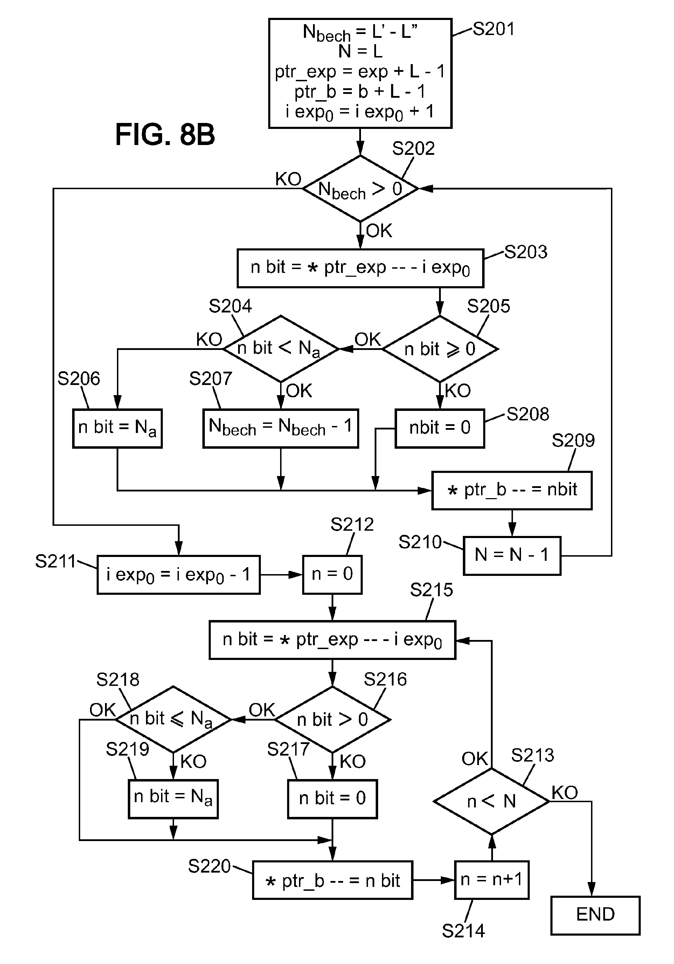

Il convient d'indiquer ici que le terme "sinon" en sortie du test S106 peut impliquer l'instruction « ELSE » qui suit habituellement l'instruction "IF" du test S106. Une telle réalisation est bien illustrée sur la figure 8A à titre d'exemple explicatif. Toutefois, en pratique, il est rappelé que ces deux instructions (« IF » et « ELSE ») ont chacune un poids de 4 en complexité. On préfère alors, en pratique de programmation, toujours borner supérieurement la différence (le poids d'une instruction « s_max » étant de 1). Le test sur la différence par rapport à la valeur $N_a$, (étape S106) est alors un test simple "if" (en lettres minuscules, dont la signification est précisée dans le tableau ci-dessus). Ainsi, en pratique, on utilise préférentiellement les bornes (s_min, ou s_max) pour la comparaison de « n bit » à 0 ou $N_a$. Néanmoins, pour clarifier les figures 8A et 8B, des instructions de type IF - ELSE y ont été représentées.

On notera aussi que les pointeurs $ptr\_exp$ et $ptr\_b$ ayant été post-incrémentés, ils pointent respectivement sur l'exposant de l'échantillon suivant et sur son allocation binaire.

Dans la deuxième boucle, le nombre de bits alloué à un échantillon ayant son exposant dans l'intervalle [$iexp_0$+1, $iexp_0$+$N_a$] est égal à la valeur de cet exposant diminué de ($iexp_0$ +1) (soit donc $exp(n)$-$iexp_0$-1). Le nombre de bits alloués aux autres échantillons est :

- 0 pour les échantillons ayant un exposant inférieur ou égal à $iexp_0$+1, ou
- $N_a$ pour les échantillons ayant un exposant strictement supérieur à $iexp_0$+$N_a$.

Pour uniformiser le traitement de $N$ derniers échantillons, on incrémente $iexp_0$ de 1 avant d'entrer dans la boucle (étape S110), et dans cette deuxième boucle, il suffit alors de borner la différence entre l'exposant d'un échantillon et cette valeur incrémentée de $iexp_0$ entre 0 et $N_a$.

Ainsi, dans la deuxième boucle (définie sur $i$ allant de 0 (étape S111) à $N$):

- la différence ($nbit$) entre l'exposant du n$^{ième}$ échantillon et $iexp_0$ est d'abord calculée à l'étape S114,
- la différence est bornée entre 0 et $N_a$ (étapes S115 à S118),
- $nbit$ est alors l'allocation binaire du n$^{ième}$ échantillon (étape S119).

Ici encore, les étapes S115 à S118 sont représentées par des instructions de type "IF" et "ELSE" à titre illustratif. Toutefois, il est préféré, en pratique de programmation, l'utilisation d'impositions de bornes.

La boucle est itérée $N$ fois (avec l'incrément de l'étape S113 et le test S112 sur $i$) pour effectuer l'allocation binaire des $N$ derniers échantillons.

Le pseudo-code de l'allocation binaire conforme à la figure 8A est donné ci-dessous :

$Nbech=L'';$

$N=L;$

$ptr\_exp = exp;$

$ptr\_b = b;$

WHILE ($Nbech > 0$) {

    $nbit = \text{sub}(*ptr\_exp++, iexp_0);$

    $nbit = \text{s\_max}(nbit,0);$

    IF($nbit> 0$) {

        $\text{if}(\text{sub}(nbit, N_a) <= 0)\ Nbech = \text{sub}(Nbech, 1);$

        $nbit = \text{s\_min}(nbit, N_a);$

    }

    $*ptr\_b++ = nbit;$

    $N= \text{sub}(N, 1);$

}

$iexp_0 = \text{add}(iexp_0,1);$

FOR($n=0; n<N; n++$) {

    $nbit = \text{sub}(*ptr\_exp++, iexp_0);$

    $nbit = \text{s\_max}(nbit, 0);$

    $nbit = \text{s\_min}(nbit, Na);$

    $*ptr\_b++ = nbit;$

}

On relèvera, dans le pseudo-code ci-dessus, que nbit est d'abord et toujours borné inférieurement par 0, avant de tester nbit >0 (au test S104), et ce toujours pour éviter l'emploi d'une instruction "ELSE" ayant un poids de 4.

La boucle conditionnelle de type « WHILE » étant plus complexe que la boucle « FOR », il peut être préférable de privilégier les itérations de la boucle FOR au détriment de la boucle WHILE et ainsi, selon les valeurs de $L''$ et de $L'$ (par exemple si $L'' > L'/2$), on peut effectuer l'allocation binaire en commençant par le dernier échantillon. Cette variante correspond au pseudo-code donné ci-après, conforme à la figure 8B, avec les étapes :

- S201 d'initialisation :

$Nbech = \text{sub}(L',L'')$;

$N = L$;

$ptr\_exp = exp + L\text{-}1$;

$ptr\_b = b + L\text{-}1$;

$iexp_0 = \text{add}(iexp_0, 1)$;

- de boucle S202 sur $Nbech$ : WHILE ($Nbech > 0$) {

  $nbit = \text{sub}(*ptr\_exp\text{--}, iexp_0)$ (étape S203);

  IF($nbit >= 0$) (test S205) {

  if(sub($nbit$, $N_a$) $<0$) ( test S204) $Nbech = \text{sub}(Nbech, 1)$ (étape S207);

  $nbit = \text{s\_min}(nbit, N_a)$ (étape S206);

  }

  $nbit = \text{s\_max}(nbit, 0)$ (étape S208);

  $*ptr\_b\text{--} = nbit$ (étape S209);

  $N = \text{sub}(N, 1)$ (étape S210);

}

$iexp_0 = \text{sub}(iexp_0, 1)$ (étape S211 en sortie de boucle sur $Nbech$ pour exécuter la deuxième boucle ci-après sur $n$);

FOR($n=0$ (étape S212); $n<N$ (test S213); $n$++ (incrément S214)) {

  $nbit = \text{sub}(*ptr\_exp\text{--}, iexp_0)$ (étape S215);

  $nbit = \text{s\_max}(nbit, 0)$ (étapes S216 et S217);

  $nbit = \text{s\_min}(nbit, N_a)$ (étapes S218 et S219);

  $*ptr\_b\text{--} = nbit$ (étape S220);

}

Une fois l'allocation binaire déterminée, la procédure du multiplexage adaptatif du signal d'amélioration de la couche "1" (L1) peut être effectuée comme dans l'état de l'art.

Cependant, l'invention offre un autre avantage. Elle permet d'effectuer en une seule passe la génération de l'allocation binaire et le multiplexage adaptatif. En effet, dans l'état de l'art, l'allocation binaire d'un échantillon n'étant connue qu'à la fin de l'allocation itérative 1 bit par 1 bit de tous les bits à allouer, le multiplexage adaptatif des bits d'amélioration des échantillons ne peut se faire qu'après la fin de l'allocation binaire itérative bit à bit de tous les échantillons. Tel n'est pas le cas dans la présente invention qui détermine l'allocation binaire d'un échantillon en une seule fois.

Il est alors possible d'effectuer le multiplexage adaptatif échantillon par échantillon, à la volée, sans attendre d'avoir déterminé l'allocation de tous les bits. La combinaison des deux étapes de génération de l'allocation binaire et du multiplexage adaptatif permet de réduire davantage la mémoire vive et la complexité : il est inutile de stocker l'allocation binaire des $L$ échantillons, avec donc un gain mémoire correspondant au tableau $b(L)$ précité et les $2L$ accès en mémoire nécessaires pour écrire et lire le nombre de bits alloués aux $L$ échantillons.

La complexité étant ainsi réduite, l'invention rend possible de nombreuses applications et notamment un traitement de signal dans une architecture de pont audio pour des téléconférences, avec décodage, mixage et ré-encodage des flux binaires entrants, comme décrit plus loin.

Plus généralement, la présente invention offre de nombreux avantages. Elle offre plusieurs variantes pour obtenir différents compromis entre complexité, mémoire vive et mémoire morte (code programmé). Dans tous les cas, les gains en mémoire vive (RAM) et en complexité sont importants. Ces gains sont obtenus sans dégradation de la qualité car l'invention permet dans une réalisation particulière de parvenir à la même allocation binaire adaptative que la procédure itérative bit par bit de l'état de l'art, ce qui permet d'assurer une compatibilité avec les codecs de l'état de l'art.

L'une des applications avantageuses de l'invention est la téléconférence audio haute qualité. Dans le cas d'une architecture de communication centralisée basée sur une unité de contrôle multipoint (ou MCU pour « Multipoint Control Unit »), un pont audio effectue un décodage des flux binaires entrants, ainsi que leur mixage, puis il ré-encode les signaux mixés pour les envoyer vers des terminaux distants.

Selon le nombre de flux à traiter, la complexité peut être importante. Pour limiter cette complexité, une technique de mixage partiel peut être prévue pour mixer les flux codés suivant le standard G.711.1. Ainsi, en contexte de codage hiérarchique au sens de G.711.1, plutôt que de décoder entièrement les flux binaires, seules les couches coeur (compatibles G.711) sont décodées et mixées, avant d'être ré-encodées, les couches d'amélioration (basse et haute) n'étant pas décodées. On peut en variante sélectionner un flux actif parmi tous les flux entrants et retransmettre aux autres terminaux distants ses couches d'amélioration combinées aux couches coeur mixées et ré-encodées. Cette technique de mixage partiel permet de réduire considérablement la complexité tout en garantissant la continuité du mixage au niveau de la couche coeur, car seules les couches d'amélioration sont commutées. Cependant, l'amélioration de la qualité de la communication apportée par les couches d'extension est perdue.

L'invention, en réduisant considérablement la complexité de décodage de la couche d'amélioration de la bande basse des flux entrants et le ré-encodage des signaux mixés améliorés, permet d'étendre le mixage partiel à toutes les bandes basses améliorées en limitant la commutation aux couches de la bande haute. La continuité des bandes basses mixées est ainsi assurée, ce qui améliore la qualité des flux mixés pour une augmentation de complexité raisonnable.

En référence à la figure 10, pour un pont de téléconférence DIS entre par exemple trois terminaux TER-A, TER-B, TER-C, il peut être décidé dans l'exemple représenté que le pont DIS enrichisse le signal G.711.1 du terminal TER-A pour les terminaux TER-B et TER-C, et mixe néanmoins les couches des bandes basses (couche coeur L0 et couche d'amélioration L1):

- des terminaux TER-B et TER-C pour le terminal TER-A (L0+L1[B+C]),
- des terminaux TER-A et TER-C pour le terminal TER-B (L0+L1 [A+C]),
- et des terminaux TER-A et TER-B pour le terminal TER-C (L0+L1 [A+B]),

en fournissant en outre le flux de la couche d'amélioration L2[A] du terminal TER-A aux terminaux TER-B et TER-C.

Avantageusement, le décodage des trois couches L1 et le ré-encodage des couches d'amélioration L1 dans les trois mixages avec les couches basses L0 sont effectuées à faible complexité, et ce grâce à la mise en oeuvre de la présente invention.

Il est présenté en Annexes 1 et 2 ci-après deux exemples de réalisation de pseudo-codes correspondant à deux situations respectives :

- où le multiplexage s'effectue conformément à l'état de l'art selon la recommandation actuelle G.711.1 (premier exemple de réalisation de l'Annexe 1),
- où le multiplexage s'effectue à la volée après allocation binaire de chaque échantillon (deuxième exemple de réalisation de l'Annexe 2).

Dans le cadre de la recommandation G.711.1, il faut améliorer le codage de 40 échantillons avec 80 bits. Le nombre de valeurs d'exposants $N_e$ est alors ici égal à 8, le nombre de bits d'amélioration maximum $N_a$ étant égal à 3.

Dans le premier mode de réalisation, les cumuls des compteurs d'exposants sont calculés par la formule de récurrence et ils ne sont pas stockés.

Pour gagner davantage en mémoire vive et en complexité, dans le second mode de réalisation, les étapes de calcul de l'allocation binaire et multiplexage adaptatif sont combinées et le tableau d'allocation binaire n'est pas stocké.

Dans le premier mode de réalisation, on prévoit deux tableaux d'entiers sur 16 bits (Word16), l'un de dimension 10 (=8+3-1) pour stocker les compteurs d'exposants, le deuxième de dimension 40 pour stocker l'allocation binaire des 40 échantillons.

Le pseudo-code est donné en Annexe 1, dans laquelle :

- COM-1 correspond au commentaire : pointeurs sur les tableaux,
- COM-2 correspond au commentaire : pointeur à l'adresse de cnt[2], nombre d'échantillons ayant 0 comme exposants,
- COM-3 : initialisation à zéro du compteur d'exposants,
- COM-4 : calcul de la table des compteurs d'exposants,
- COM-5 : accès mémoire pour lire l'exposant de l'échantillon n,
- COM-6 : pointage à l'adresse de cnt0[iexp],

- COM-7 : incrément de 1 de cnt0[iexp] et écriture en mémoire,
- COM-8 : recherche du plus grand exposant des 40 échantillons : dernier élément non nul de cnt,
- COM-9 : recherche de iexp0: plus grand exposant des échantillons ne recevant pas de bits d'amélioration,
- COM-10 : calcul du cumul des compteurs d'exposants cum par récurrence,
- COM-11 : addition de cnt0[iexp0] à cum: cum = cnt0[iexp0+2] + cnt0[iexp0+1] + cnt0[iexp0],
- COM-12 : décrément de 1 de iexp0,
- COM-13 : soustraction de cnt0[iexp0+3] à cum -> cum = cnt0[iexp0+2] + cnt0[iexp0+1]
- COM-14 : calcul de nbEch1: nombre d'échantillons dont l'exposant est dans l'intervalle [iexp0+1, iexp0+3] qui recevront exp(n) -iexp0 bits d'amélioration,
- COM-15 : calcul du nombre d'échantillons dont l'exposant est dans l'intervalle [iexp0+1, iexp0+3] : cnt0[iexp0+3] + cnt0[iexp0+2] + cnt0[iexp0+1], par addition de cnt0[iexp0+3] à cum,
- COM-16 : calcul de nbEch1 en additionnant cum au nombre de bits (négatif) en sortie de boucle conditionnelle,
- COM-17 : allocation binaire selon la différence entre l'exposant iexpn d'un échantillon et iexp0 ; si iexpn <= iexp0: nbBit = 0 ; si iexp0< iexpn <= 3 (échantillons avec exposant dans l'intervalle [iexp0+1, iexp0+3]) ; nbBit= iexpn -iexp0, pour les nbEch1 premiers échantillons ; nbBit= iexpn-iexp0-1, pour les derniers échantillons ; si iexpn>iexp0+3: nbBit = 3,
- COM-18 : calcul de nbBit comme la différence entre l'exposant de l'échantillon et de iexp0,
- COM-19 : test si l'exposant de l'échantillon est dans l'intervalle [iexp0+1,iexp0+3], en testant si nbBit est inférieur ou égal à 3,
- COM-20 : l'exposant est dans l'intervalle, décrément du nombre d'échantillons de cet intervalle auxquels sont alloués iexp-iexp0 bits,
- COM-21 : nombre maximum de bits alloués limité à 3,
- COM-22 : décrément compteur d'échantillons ayant reçu une allocation binaire,
- COM-23 : allocation binaire aux derniers nbEch0 échantillons : parmi nbEch0 échantillons, les échantillons dont l'exposant est dans l'intervalle [iexp0+1, iexp0+3], reçoivent iexpn-iexp0-1 bits.

Par ailleurs, pour tenir compte de la complexité d'un adressage non régulier, une addition (add(0,0)) a été indiquée.

On note que grâce à la recherche de iexpMax, plus grand exposant des 40 échantillons, le calcul des cumuls des compteurs est en moyenne moins complexe (puisqu'on ne calcule pas les cumuls pour les exposants supérieurs à iexpMax).

Dans une variante possible, on distingue le cas particulier iexpMax = 0 (avec dans ce cas l'allocation de 2 bits à chacun des 40 échantillons). Dans cette variante, après avoir déterminé iexpMax, on teste s'il est strictement positif (IF (iexpMax >0)) auquel cas les étapes de détermination de iexp0, de calcul de NbEch1, et d'allocation binaire par le calcul de la différence avec iexp0 dans deux boucles sont effectuées. Sinon (iexpMax =0), ces étapes sont omises, et 2 bits sont alloués à chaque échantillon. Dans cette variante où le cas iexpMax =0 est traité à part, on peut diminuer de 1 la dimension du tableau *cnt* (avec une initialisation de cnt0 à cnt +1). Par contre, distinguer ce cas particulier augmente la taille de la mémoire programme (en nécessitant un jeu d'instructions programmes supplémentaires pour ce cas). Ce cas est spécialement intéressant quand l'étape d'allocation binaire est combinée avec celle du multiplexage (selon le deuxième mode de réalisation décrit ci-après), la procédure de multiplexage étant dans ce particulier très simple et peu complexe.

On voit donc que l'invention offre plusieurs variantes possibles selon les applications visées.

Dans le deuxième mode de réalisation présenté en Annexe 2, les étapes de calcul de l'allocation binaire et de multiplexage adaptatif sont combinées et le tableau d'allocation binaire n'a pas besoin d'être stocké. Les premières étapes (calcul de la table des compteurs d'exposants, recherche du plus grand exposant des 40 échantillons, recherche du plus grand exposant des échantillons ne recevant pas de bits d'amélioration, calcul du nombre d'échantillons ayant un exposant dans l'intervalle [iexp0+1, iexp0+3] qui recevront (exp(n)-iexp0) bits d'amélioration) sont les mêmes que dans le premier mode de réalisation ci-avant.

Le cas général (iexpMax >0) est d'abord donné.

Après les étapes préliminaires, le multiplexage adaptatif est effectué dans les deux boucles de calcul d'allocation binaire. Avant la boucle conditionnelle (WHILE(nbEch1 > 0)), les mêmes initialisations que celles décrites dans l'art antérieur sont effectuées.

Le pseudo-code de l'Annexe 2 appelle les commentaires suivants :

- COM-50 : extrait de la routine mux_cod, cette routine effectue le multiplexage adaptatif comporte le même jeu d'instructions que dans l'état de l'art ;
- COM-51 : mais contrairement à l'état de l'art, la routine peut ne pas être appelée si aucun bit n'est alloué ; dans une variante pour éviter un test (ELSE) et diminuer le nombre d'instructions, on peut comme dans l'état de l'art appeler la routine pour tous les échantillons y compris ceux ayant 0 bit d'amélioration alloué.

L'invention permet ainsi de réduire de manière significative la taille de la mémoire vive nécessaire et le nombre de calculs. De plus, grâce à cette réduction de complexité et de mémoire, on peut améliorer la qualité du mixage partiel notamment dans les ponts de conférence en remplaçant avantageusement le mixage partiel limité aux couches coeur par le mixage partiel des signaux des bandes basses complets (comprenant les couches coeur et d'amélioration hiérarchique).

<u>**ANNEXE 1**</u>

```
Word16 cnt[10], b[40];
Word16 *ptr_cnt, *ptr_cnt2, *ptr_exp, *ptr_b; /* COM-1 */
Word16 iexp, n, iexpMax, iexp0, cum, nbBit;
Word16 *ptr_cnt0 = cnt+2; /* COM-2 */
/* COM-3 */
ptr_cnt = cnt;
FOR(iexp=0; iexp<10; iexp++)
{
  *ptr_cnt++ = 0; move16();
}
/* COM-4 */
ptr_exp =exp;
FOR(n=0; n<40; n++)
{
  iexp = *ptr_exp++; move16();/* COM-5 */
  ptr_cnt = cnt0 + iexp; add(0,0); /* COM-6 */
  *ptr_cnt = add(*ptr_cnt, 1); move16();/* COM-7 */
}
/* COM-8 */
iexpMax = 7; move16();
ptr_cnt = cnt0 + iexpMax; add (0,0);
WHILE(*ptr_cnt-- == 0) iexpMax = sub(iexpMax,1);
/* COM-9 */
/* COM-10 */
ptr_cnt++; /* ptr_cnt = &cnt0[iexpMax] */
ptr_cnt2 = ptr_cnt;
nbBit= sub(80, *ptr_cnt--); /* nbBit = 80 - cnt0[iexpMax] */
cum = add(*ptr_cnt2, *ptr_cnt--); /* cum = cnt0[iexpMax] + cnt0[iexpMax-1] */
nbBit= sub(nbBit, cum);
/* nbBit = 80 - cnt0[iexpMax] - (cnt0[iexpMax] + cnt0[iexpMax-1]) */
iexp0 = sub(iexpMax, 2);     WHILE(nbBit> 0) {
  /* COM-11 */
    cum = add(cum, *ptr_cnt--);
    nbBit= sub(nbBit, cum);
  /* COM-12 */
    iexp0 = sub(iexp0, 1);
  /* COM-13 */
    cum = sub(cum, *ptr_cnt2--);
   }
/* COM-14 */
/* COM-15 */
  cum= add(cum, *(++ptr_cnt2));
/* COM-16 */
  nbEch1= add(nbBit, cum);
/* COM-17 */
  ptr_exp =exp;
  ptr_b = b;
  WHILE(nbEch1 > 0) {
/* COM-18 */
    nbBit = sub(*ptr_exp++, iexp0);
```

```
      nbBit = s_max (nbBit,0); /* si exp <iexp0, 0 bit */
      IF(nbBit> 0) {
/* COM-19 */
      if(sub(nbBit, 3) <= 0) {
/* COM-20 */
          nbEch1 = sub(nbEch1, 1);
      }
/* COM-21 */
      nbBit = s_min(nbBit, 3);
    }
    *ptr_b++ = nbBit; move16();
    nbEch0 = sub(nbEch0 ,1); /* COM-22 */
  }
/* COM-23 */
iexp0= add(iexp0, 1);
  FOR(i=0; i<nbEch0; i++) {
    nbBit = sub(*ptr_exp++, iexp0);
    nbBit = s_max (nbBit,0);
    nbBit = s_min(nbBit, 3);
    *ptr_b++ = nbBit; move16();
  }
```

**ANNEXE 2**

```
  WHILE(nbEch1 > 0)
  {
    nbBit = sub(*ptr_exp++, iexp0);
    IF(nbBit> 0)
    {
      nbShr = sub(3, nbBit);
      if(nbShr >= 0) nbEch1 = sub(nbEch1, 1);
      nbShr = s_max(nbShr, 0);
      *ptr = shr(*ptr, nbShr); move16();
      nbBit = sub(3, nbShr);
      mux_cod(&tmp1, nbBit, *ptr, &bit_pos, &pcode1);
    }
    ELSE
    {
      *ptr = shr(*ptr, 3); move16();
    }
    ptr++;
    nbEch0 = sub(nbEch0 ,1);
  }
  iexp0= add(iexp0, 1);
  FOR(i=0; i<nbEch0; i++)
  {
    nbBit = sub(*ptr_exp++, iexp0);
    IF(nbBit> 0)
    {
      nbBit = s_min(nbBit, 3);
      nbShr =sub(3, nbBit);
      *ptr = shr(*ptr, nbShr); move16();
      mux_cod(&tmp1, nbBit, *ptr, &bit_pos, &pcode1);
    }
    ELSE
    {
      *ptr = shr(*ptr, 3); move16();
    }
    ptr++;
  }
```

```
/* COM 50 */
octet = shl(octet, nbBit);
octet = s_or(octet, val);
bit_pos= add(bit_pos, nbBit);
IF (sub(bit_pos, 8) >= 0)
{
  bit_pos= sub(bit_pos, 8);
  temp = shr(octet, bit_pos);
  octet = sub(octet, shl(temp, bit_pos));
  **ptr_bst = (unsigned char)temp; move16();
  (*ptr_bst)++;
}
/* COM-51 */
WHILE(nbEch1 > 0)
{
  nbBit = sub(*ptr_exp++, iexp0);
  nbBit = s_max (nbBit,0);
  IF(nbBit> 0)
  {
    if(sub(nbBit, 3) <= 0)nbEch1 = sub(nbEch1, 1);
    nbBit = s_min(nbBit, 3);
  }
  nbShr = sub(3, nbBit);
  *ptr = shr(*ptr, nbShr); move16();
  mux_cod(&tmp1, nbBit, *ptr, &bit_pos, &pcode1);
  ptr++;
  nbEch0 = sub(nbEch0,1);
}
iexp0= add(iexp0, 1);
FOR(i=0; i<nbEch0; i++)
{
  nbBit = sub(*ptr_exp++, iexp0);
  nbBit = s_max (nbBit,0);
  nbBit = s_min(nbBit, 3);
  nbShr = sub(3, nbBit);
  *ptr = shr(*ptr, nbShr); move160;
  mux_cod(&tmp1, nbBit, *ptr, &bit_pos, &pcode1);
}
```

## Revendications

1. Procédé d'allocation binaire dans un codage/décodage hiérarchique comportant un codage/décodage d'une couche d'amélioration d'un signal numérique comportant une succession de $L$ échantillons, chaque échantillon comportant une mantisse et un exposant, le procédé comportant l'allocation d'un nombre prédéterminé $N_b$ de bits d'amélioration à une partie au moins des $L$ échantillons de valeurs d'exposant les plus élevées,
   **caractérisé en ce qu'**il comporte les étapes :

   a) dénombrer les exposants des $L$ échantillons ayant chacun une valeur donnée,
   b) calculer au moins un cumul de dénombrements d'exposants par valeurs décroissantes d'exposant jusqu'à approcher par excès le nombre prédéterminé $N_b$, pour
   c) déterminer une valeur seuil de plus grand exposant ($iexp_0$) d'échantillon pour lequel plus aucun bit d'amélioration n'est disponible, et

   allouer les $N_b$ bits d'amélioration, selon des règles choisies, aux échantillons dont l'exposant est supérieur à ladite valeur seuil ($iexp_0$).

2. Procédé selon la revendication 1, **caractérisé en ce que**, selon lesdites règles choisies, on prévoit un nombre maximum $N_a$ de bits à allouer pour un échantillon, et on réserve :

   - $N_a$ bits pour une allocation à chaque échantillon dont l'exposant est supérieur à une somme de la valeur seuil

(iexp$_0$) et du nombre maximum $N_a$,
- aucun bit pour des échantillons dont l'exposant est inférieur ou égal à ladite valeur seuil (iexp$_0$), et
- un nombre de bits complémentaires parmi le nombre $N_b$ de bits, pour une allocation aux échantillons dont l'exposant est compris entre la valeur seuil (iexp$_0$) plus un et la somme de la valeur seuil et du nombre maximum $N_a$.

**3.** Procédé selon la revendication 2, **caractérisé en ce qu'**on alloue à chaque échantillon dont l'exposant est compris entre la valeur seuil plus un et la somme de la valeur seuil et du nombre maximum $N_a$ :

- la différence entre l'exposant d'un échantillon (iexp(n)) et la valeur seuil (iexp$_0$),
- ou cette différence moins un, selon un critère choisi.

**4.** Procédé selon la revendication 3, **caractérisé en ce que** le critère choisi correspond à un ordre de position de l'échantillon dans la succession d'échantillons.

**5.** Procédé selon l'une des revendications 2 à 4, **caractérisé en ce qu'**il comporte :

b1) une détermination d'une plus grande valeur d'exposant (iexp$_{max}$) parmi les $L$ échantillons ;
b2) un cumul des nombres d'exposants depuis la plus grande valeur d'exposant jusqu'à ladite plus grande valeur décrémentée $N_a$ fois ; et
b3) une boucle conditionnelle telle que :

- si le cumul reste inférieur au nombre total de bits $N_b$ à allouer aux $L$ échantillons, ce cumul est ajouté à un nouveau cumul calculé par la mise en oeuvre de l'opération b2) avec une décrémentation de un de la plus grande valeur d'exposant, le résultat de cette décrémentation étant pris pour la mise en oeuvre de l'opération b2) en tant que plus grande valeur d'exposant, avec une itération en boucle de l'opération b2) tant que ledit cumul résultant de l'opération b2) reste inférieur au nombre $N_b$,
- sinon, on calcule un nombre de bits complémentaires restants à une itération immédiatement précédente de l'opération b2), pour déterminer un nombre ($L''$) d'échantillons dont l'exposant est compris entre la valeur seuil plus un et la somme de la valeur seuil et du nombre maximum $N_a$.

**6.** Procédé selon l'une des revendications 2 à 5, **caractérisé en ce que** l'allocation binaire aux $L$ échantillons est effectuée par l'exécution de deux boucles :

- une première boucle jusqu'à ce que l'allocation binaire à des échantillons ($L''$) ayant un exposant compris entre la valeur seuil plus un et la somme de la valeur seuil et du nombre maximum $N_a$ soit effectuée, un nombre d'itérations de la première boucle étant compté,
- puis, une deuxième boucle pour effectuer l'allocation binaire des derniers échantillons restants, itérée un nombre de fois qui est fonction dudit nombre d'itérations de la première boucle.

**7.** Procédé selon l'une des revendications précédentes, **caractérisé en ce qu'**un tableau de compteurs d'exposants (*cnt0*) est établi à l'étape a) et **en ce qu'**un pointeur d'adresse dans le tableau est décrémenté dans une boucle conditionnelle pour la mise en oeuvre de l'étape b).

**8.** Procédé selon la revendication 6 prise en combinaison avec la revendication 5, **caractérisé en ce que** la détermination de la plus grande valeur d'exposant (iexp$_{max}$) parmi les $L$ échantillons est effectuée par lecture dudit tableau.

**9.** Procédé selon l'une des revendications précédentes, **caractérisé en ce que**, le procédé comportant, au codage, la composition d'un train binaire d'un signal d'amélioration résultant du codage de la couche d'amélioration, ladite composition est effectuée à la volée après allocation binaire de chaque échantillon.

**10.** Procédé selon l'une des revendications précédentes, **caractérisé en ce que** l'étape de quantification est de type à Modulation par Impulsion et Codage selon une loi de codage logarithmique de compression d'amplitude de type A ou de type $\mu$ conforme à la recommandation ITU-T G.711.1.

**11.** Application du procédé selon l'une des revendications précédentes au traitement de signal par décodage au moins partiel, mixage et ré-encodage au moins partiel de flux binaires entrants, dans une architecture de pont audio pour téléconférence.

**12.** Programme informatique, **caractérisé en ce qu'**il comporte des instructions pour la mise en oeuvre du procédé selon l'une des revendications 1 à 10, lorsqu'elles sont exécutées par un processeur (PROC ; PROC').

**13.** Dispositif codeur d'une couche d'amélioration dans un codage hiérarchique d'un signal audionumérique comportant une succession d'échantillons, **caractérisé en ce qu'**il comporte des moyens informatiques (PROC, MEM) pour la mise en oeuvre du procédé selon l'une des revendications 1 à 10 et/ou pour la mise en oeuvre de l'application selon la revendication 11.

**14.** Dispositif décodeur d'une couche d'amélioration dans un décodage hiérarchique d'un signal audionumérique comportant une succession d'échantillons, **caractérisé en ce qu'**il comporte des moyens informatiques (PROC', MEM') pour la mise en oeuvre du procédé selon l'une des revendications 1 à 10 et/ou pour la mise en oeuvre de l'application selon la revendication 11.

**Patentansprüche**

**1.** Bitzuteilungsverfahren in einer hierarchischen Kodierung/Dekodierung, das ein Kodieren/Dekodieren einer Verbesserungsschicht eines digitalen Signals umfasst, die eine Abfolge von $L$ Abtastwerten umfasst, wobei jeder Abtastwert eine Mantisse und einen Exponenten umfasst, wobei das Verfahren das Zuteilen einer vorbestimmten Anzahl $N_b$ von Verbesserungsbits zu mindestens einem Teil der $L$ Abtastwerte mit den höchsten Exponentenwerten umfasst, **dadurch gekennzeichnet, dass** es die folgenden Schritte umfasst:

a) Zählen der Exponenten der $L$ Abtastwerte, die jeweils einen gegebenen Wert haben,
b) Berechnen mindestens einer Summierung von Zählungen von Exponenten nach sinkenden Exponentenwerten bis zum Annähern durch Überschuss mit der vorbestimmten Anzahl $N_b$, um
c) einen Schwellenwert mit dem größten Abtastwertexponenten ($iexp_0$) zu bestimmen, für den kein Verbesserungsbit mehr verfügbar ist, und

Zuteilen der $N_b$ Verbesserungsbits gemäß den ausgewählten Regeln zu den Abtastwerten, deren Exponent größer ist als der Schwellenwert ($iexp_0$).

**2.** Verfahren nach Anspruch 1, **dadurch gekennzeichnet, dass** gemäß den ausgewählten Regeln eine maximale Anzahl $N_a$ für einen Abtastwert zuzuteilender Bits vorgesehen ist, und Folgendes reserviert ist:

- $N_a$ Bits für eine Zuteilung für jeden Abtastwert, dessen Exponent größer ist als eine Summe aus dem Schwellenwert ($iexp_0$) und der maximalen Anzahl $N_a$,
- kein Bit für Abtastwerte, deren Exponent kleiner oder gleich dem Schwellenwert ($iexp_0$) ist, und
- eine Anzahl ergänzender Bits der Anzahl $N_b$ Bits für eine Zuteilung zu den Abtastwerten, deren Exponent zwischen dem Schwellenwert ($iexp_0$) plus eins und der Summe aus dem Schwellenwert und der maximalen Anzahl $N_a$ liegt.

**3.** Verfahren nach Anspruch 2, **dadurch gekennzeichnet, dass** man jedem Abtastwert, dessen Exponent zwischen dem Schwellenwert plus eins und der Summe aus dem Schwellenwert und der maximalen Anzahl $N_a$ liegt, Folgendes zuteilt:

• den Unterschied zwischen dem Exponenten eines Abtastwerts ($iexp(n)$) und dem Schwellenwert ($iexp_0$),
• oder, gemäß einem ausgewählten Kriterium, diesen Unterschied minus eins.

**4.** Verfahren nach Anspruch 3, **dadurch gekennzeichnet, dass** das ausgewählte Kriterium einer Positionsreihenfolge des Abtastwerts in der Abfolge von Abtastwerten entspricht.

**5.** Verfahren nach einem der Ansprüche 2 bis 4, **dadurch gekennzeichnet, dass** es Folgendes umfasst:

b1) eine Bestimmung eines größten Exponentenwerts ($iexp_{max}$) unter den $L$ Abtastwerten,
b2) eine Summe der Anzahlen von Exponenten seit dem größten Exponentenwert bis zu dem größten Wert $N_a$ Mal verringert, und
b3) eine bedingte Schleife derart, dass:

• falls die Summierung kleiner bleibt als die Gesamtanzahl Bits $N_b$, die den $L$ Abtastwerten zuzuteilen ist, diese Summierung zu einer neuen Summierung hinzugefügt wird, die durch Umsetzen des Vorgangs b2) mit einer Verringerung um eins des größten Exponentenwerts berechnet wird,

wobei das Resultat dieser Verringerung zum Umsetzen des Vorgangs b2) als größter Exponentenwert genommen wird, mit einer Schleifeniteration des Vorgangs b2) so lange, wie die Summierung, die aus dem Vorgang b2) resultiert, niedriger bleibt als die Anzahl $N_b$,

• anderenfalls eine Anzahl komplementärer restlicher Bits einer Iteration unmittelbar vor der Operation b2) berechnet wird, um eine Anzahl ($L''$) von Abtastwerten zu bestimmen, deren Exponent zwischen dem Schwellenwert plus eins und der Summe aus dem Schwellenwert und der maximalen Anzahl $N_a$ liegt.

6. Verfahren nach einem der Ansprüche 2 bis 5, **dadurch gekennzeichnet, dass** die Bitzuteilung zu den $L$ Abtastwerten durch Ausführen von zwei Schleifen ausgeführt wird:

   - eine erste Schleife, bis die Bitzuteilung zu den Abtastwerten ($L''$), die einen Exponenten zwischen dem Schwellenwert plus eins und der Summe aus dem Schwellenwert und der maximalen Anzahl $N_a$ haben, ausgeführt ist, wobei eine Anzahl von Iterationen der ersten Schleife gezählt wird,
   - dann eine zweite Schleife, um die Bitzuteilung der letzten restlichen Abtastwerte auszuführen, die eine Anzahl Male wiederholt wird, die von der Anzahl von Iterationen der ersten Schleife abhängt.

7. Verfahren nach einem der vorhergehenden Ansprüche, **dadurch gekennzeichnet, dass** eine Exponentenzählertabelle (*cnt0*) bei Schritt a) erstellt wird, und dass ein Adresspointer in der Tabelle in einer bedingten Schleife für die Umsetzung des Schritts b) verringert wird.

8. Verfahren nach Anspruch 6, kombiniert mit Anspruch 5 genommen, **dadurch gekennzeichnet, dass** die Bestimmung des größten Exponentenwerts ($iexp_{max}$) unter den L Abtastwerten durch Lesen der Tabelle ausgeführt wird.

9. Verfahren nach einem der vorhergehenden Ansprüche, **dadurch gekennzeichnet, dass** das Verfahren beim Kodieren die Zusammenstellung eines Bitstroms eines Verbesserungssignals, das aus der Kodierung der Verbesserungsschicht resultiert, umfasst, wobei die Zusammensetzung im gleichen Zug nach der Bitzuteilung jedes Abtastwerts erfolgt.

10. Verfahren nach einem der vorhergehenden Ansprüche, **dadurch gekennzeichnet, dass** der Quantifizierungsschritt des Typs mit Pulsmodulation und Kodierung gemäß einem logarithmischen Kodierungsgesetz zur Amplitudenkompression des Typs A oder des Typs μ gemäß der Empfehlung ITU-T G.711.1 ist.

11. Anwendung des Verfahrens nach einem der vorhergehenden Ansprüche an die Signalverarbeitung durch mindestens teilweises Dekodieren, Mischen und mindestens teilweises Neukodieren eingehender Bitströme in einer Audiobrückenarchitektur für Telekonferenz.

12. Informatikprogramm, **dadurch gekennzeichnet, dass** es Anweisungen zum Umsetzen des Verfahrens nach einem der Ansprüche 1 bis 10 umfasst, wenn sie von einem Prozessor (PROC; PROC') ausgeführt werden.

13. Kodierungsvorrichtung einer Verbesserungsschicht in einer hierarchischen Kodierung eines digitalen Audiosignals, das eine Abfolge von Abtastwerten umfasst, **dadurch gekennzeichnet, dass** sie Informatikmittel (PROC, MEM) zum Umsetzen des Verfahrens nach einem der Ansprüche 1 bis 10 und/oder zum Umsetzen der Anwendung gemäß Anspruch 11 umfasst.

14. Dekodierungsvorrichtung einer Verbesserungsschicht in einer hierarchischen Dekodierung eines digitalen Audiosignals, das eine Abfolge von Abtastwerten umfasst, **dadurch gekennzeichnet, dass** sie Informatikmittel (PROC', MEM') zum Umsetzen des Verfahrens nach einem der Ansprüche 1 bis 10 und/oder zum Umsetzen der Anwendung nach Anspruch 11 umfasst.

## Claims

1. Method for binary allocation in hierarchical coding/decoding involving coding/decoding of an improvement layer for a digital signal having a succession of $L$ samples, each sample having a mantissa and an exponent, the method involving the allocation of a predetermined number $N_b$ of improvement bits to a portion at least of the $L$ samples of highest exponent values,
**characterized in that** it has the steps of:

a) counting the exponents of the $L$ samples each having a given value,
b) computing at least one cumulative count of exponents by decreasing exponent values until the predetermined number $N_b$ is approached through excess, for the purpose of
c) determining a threshold value for the greatest sample exponent ($iexp_0$) for which no further improvement bit is available, and

allocating the $N_b$ improvement bits, according to chosen rules, to the samples for which the exponent is higher than said threshold value ($iexp_0$).

2. Method according to Claim 1, **characterized in that**, according to said chosen rules, a maximum number $N_a$ of bits to be allocated for a sample is provided, and the following are reserved:

- $N_a$ bits for an allocation to each sample of which the exponent is higher than a sum of the threshold value ($iexp_0$) and the maximum number $N_a$,
- no bit for samples of which the exponent is lower than or equal to said threshold value ($iexp_0$), and
- a number of complementary bits among the number $N_b$ of bits, for an allocation to the samples of which the exponent is between the threshold value ($iexp_0$) plus one and the sum of the threshold value and the maximum number $N_a$.

3. Method according to Claim 2, **characterized in that** the following is allocated to each sample of which the exponent is between the threshold value plus one and the sum of the threshold value and the maximum number $N_a$:

- the difference between the exponent of a sample ($iexp(n)$) and the threshold value ($iexp_0$),
- or this difference minus one, according to a chosen criterion.

4. Method according to Claim 3, **characterized in that** the chosen criterion corresponds to a position order for the sample in the succession of samples.

5. Method according to one of Claims 2 to 4, **characterized in that** it involves:

b1) determination of a greater exponent value ($iexp_{max}$) among the $L$ samples;
b2) accumulation of the numbers of exponents from the greatest exponent value to said greatest value decremented $N_a$ times; and
b3) a conditional loop such as:

- if the accumulation remains lower than the total number of bits $N_b$ to allocate to the $L$ samples, this accumulation is added to a new accumulation computed by implementing operation b2) with decrementation of the greatest exponent value by one, the result of this decrementation being taken, for the implementation of operation b2), as greatest exponent value, with looped iteration of operation b2) as long as said accumulation resulting from operation b2) remains lower than the number $N_b$,
- otherwise, a number of complementary bits remaining from an immediately preceding iteration of operation b2) is computed in order to determine a number ($L''$) of samples of which the exponent is between the threshold value plus one and the sum of the threshold value and the maximum number $N_a$.

6. Method according to one of Claims 2 to 5, **characterized in that** the binary allocation to the $L$ samples is performed by executing two loops:

- a first loop until the binary allocation to samples ($L''$) having an exponent between the threshold value plus one and the sum of the threshold value and the maximum number $N_a$ is performed, a number of iterations of the first loop being counted,
- then, a second loop in order to perform the binary allocation of the last remaining samples, iterated a number of times that is dependent on said number of iterations of the first loop.

7. Method according to one of the preceding claims, **characterized in that** a table of exponent counters ($cnt0$) is set up in step a) and **in that** an address pointer in the table is decremented in a conditional loop for the implementation of step b).

8. Method according to Claim 6 taken in combination with Claim 5, **characterized in that** the determination of the greatest exponent value ($iexp_{max}$) among the L samples is performed by reading said table.

9. Method according to one of the preceding claims, **characterized in that**, the method involving, on coding, the composition of a binary train for an improvement signal resulting from the coding of the improvement layer, said composition is performed on the fly after binary allocation of each sample.

10. Method according to one of the preceding claims, **characterized in that** the step of quantization is of pulse code modulation type according to a logarithmic coding law for amplitude compression of type-A or type-$\mu$ in accordance with ITU-T recommendation G.711.1.

11. Application of the method according to one of the preceding claims to signal processing by at least partial decoding, mixing and at least partial reencoding of incoming bit streams, in an audio bridge architecture for teleconferencing.

12. Computer program **characterized in that** it has instructions for implementing the method according to one of Claims 1 to 10 when they are executed by a processor (PROC; PROC').

13. Coding device for an improvement layer in hierarchical coding of a digital audio signal having a succession of samples, **characterized in that** it has computer means (PROC, MEM) for implementing the method according to one of Claims 1 to 10 and/or for implementing the application according to Claim 11.

14. Decoding device for an improvement layer in hierarchical decoding for a digital audio signal having a succession of samples, **characterized in that** it has computer means (PROC', MEM') for implementing the method according to one of Claims 1 to 10 and/or for implementing the application according to Claim 11.

FIG. 1

FIG. 2

EP 2 769 378 B1

FIG. 3

30

$$b\,(n) = 0$$
$$N_b = 80$$
$$i\,exp = 9$$
$$n = 0, \ldots , 39$$

S21

$$min\,(cnt\,(i\,exp),\,N_b)) = m$$

S22

$$n = map\,(i\,exp,\,j)$$

S23

$$b\,(n) = b\,(n) + 1$$

$$j = 0, \ldots , m\text{-}1$$

S24

$$N_b = N_b - m$$

S25

$$N_b = 0\,?$$

KO

$$i\,exp = i\,exp\text{-}1$$

OK

TAB

# FIG. 4

cnt (0) [i exp] = 0
adr_exp = exp
i exp = 0, ... , $N_e$ - 1
n = 0

i expn = ∗ adr_exp ++ ⎯A

adr_cnt = cnt 0 + i expn ⎯B

∗ adr_cnt = ∗ adr_cnt + 1 ⎯C

n = n + 1

KO ◇ n = L

OK

END

FIG. 5

## FIG. 6

adr_cnt 0 = cnt 0;
adr_cnt_cum = cnt_cum
j = 0

adr_cnt = cnt 0;
cum = 0        — D,E

cum = cum + ∗ adr_cnt --
i = 0, ... , N$_a$ - 1        — F

i = i + 1

i = N$_a$        KO / OK

∗ adr_cnt_cum ++ = cum;
cnt 0 ++        — G

j = j + 1

j = N$_a$ + N$_e$ - 1        KO / OK

END

EP 2 769 378 B1

EP 2 769 378 B1

```
                                    S52
  ┌──────────────────┐        ╱◇╲              ┌──────────────┐
  │ i exp_max = N_e - 1│      ╱     ╲    KO     │  i exp_max   │
  │   adr_cnt =      │─────▶◇ * adr_cnt --◇────▶│              │
  │  cnt 0 + N_e - 1 │      ╲  = = 0  ╱          └──────────────┘
  └──────────────────┘        ╲◇╱                      │
        │                    OK│          S53          │  S54
       S51                     ▼        ╱               │
                    ┌───────────────────────┐          │
                    │ i exp_max = i exp_max -1│          │
                    └───────────────────────┘          │
                                                        ▼
        S56                                    ┌──────────────────┐
  ┌──────────────────────┐                     │ i exp_0 = i exp_max -1│
  │  adr_cum = cnt_cum + │◀────────────────────│                  │
  │  (i exp_max + N_a - 1)│                     └──────────────────┘
  └──────────────────────┘                            S55
             │
             ▼
  ┌──────────────────────┐  S57
  │ N'_b = N_b - * adr_cum -- │
  └──────────────────────┘
   S61        │
  ┌──────┐    ▼      S58
  │i exp_0│  ╱◇╲              FIG. 7
  │      │◀─◇ N'_b > 0 ◇
  └──────┘   ╲◇╱
      KO      │
            OK│
              ▼
  ┌──────────────────────┐  S59
  │ N'_b = N'_b - * adr_cum -- │
  └──────────────────────┘
              │
              ▼
  ┌──────────────────────┐  S60
  │  i exp_0 = i exp_0 - 1  │
  └──────────────────────┘
```

$i\ exp_{max} = N_e - 1$
$adr\_cnt = cnt\ 0 + N_e - 1$   **S51**

**S52**   $*\ adr\_cnt\ --\ = = 0$

**S54**   $i\ exp_{max}$

**OK**   $i\ exp_{max} = i\ exp_{max} - 1$   **S53**

**S55**   $i\ exp_0 = i\ exp_{max} - 1$

**S56**   $adr\_cum = cnt\_cum + (i\ exp_{max} + N_a - 1)$

**S57**   $N'_b = N_b - *\ adr\_cum\ --$

**S58**   $N'_b > 0$

**S61**   $i\ exp_0$

**S59**   $N'_b = N'_b - *\ adr\_cum\ --$

**S60**   $i\ exp_0 = i\ exp_0 - 1$

**FIG. 7**

## FIG. 8A

$$N_{bech} = L''$$
$$N = L$$
$$ptr\_exp = exp$$
$$ptr\_b = b$$
— S101

S102

$N_{bech} > 0$ — KO

OK

n bit = * ptr_exp ++ - i $exp_0$ — S103

S104

n bit > 0 — OK — S106 — n bit ≤ $N_a$ — KO

KO

OK — S120

S107

S105 — n bit = 0

$N_{bech} = N_{bech} - 1$

n bit = $N_a$

S108

* ptr_b ++ = n bit

S109

N = N - 1

S111

i = 0

$i\ exp_0 = i\ exp_0 + 1$ — S110

S114

n bit = * ptr_exp ++ - i $exp_0$

S115

n bit > 0 — OK — S117 — n bit ≤ $N_a$ — OK

S116 — KO

S118 — KO

n bit = 0

n bit = $N_a$

S112

KO — i < N — OK

END

i = i + 1

* ptr_b ++ = n bit — S119

S113

## FIG. 8B

$N_{bech} = L' - L''$
$N = L$
$ptr\_exp = exp + L - 1$
$ptr\_b = b + L - 1$
$i\ exp_0 = i\ exp_0 + 1$ — S201

S202
$N_{bech} > 0$ KO ← → OK

$n\ bit = *\ ptr\_exp\ - -\ i\ exp_0$ — S203

S204        S205

KO ← $n\ bit < N_a$ ← OK $n\ bit \geqslant 0$

S206   S207    OK    KO

$n\ bit = N_a$   $N_{bech} = N_{bech} - 1$   $nbit = 0$ — S208

S209

$*\ ptr\_b\ - - = nbit$

S210 — $N = N - 1$

S211 — $i\ exp_0 = i\ exp_0 - 1$ → S212 — $n = 0$

$n\ bit = *\ ptr\_exp\ - - -\ i\ exp_0$ — S215

S218      S216

OK ← $n\ bit \leqslant N_a$ ← OK $n\ bit > 0$

S219    KO    S217    KO

$n\ bit = N_a$    $n\ bit = 0$

OK   S213

$n < N$ KO

S220 — $*\ ptr\_b\ - - = n\ bit$ → $n = n+1$    END

S214

**FIG. 9**

cut 0:
n[exp = 0] = 10
n[exp = 1] = 8
n[exp = 2] = 8
n[exp = 3] = 6
$\bullet\bullet\bullet$
$n[exp = i \; exp_{max}] \neq 0$
_____
10 + 8 + 8 + 6 + ... = L

GEN-1

$cum \; [i \; exp_{max} - N_a + 1; i \; exp_{max}] \longrightarrow N_1$
$N_1 \leqslant N_b$ ?

OK:
$cum \; [i \; exp_{max} - N_a \; ; i \; exp_{max} - 1] \longrightarrow N_2$
$N_1 + N_2 \leqslant N_b$ ?

OK:          $\bullet\bullet\bullet$

$cum \; [i \; exp_0 \; ; i \; exp_0 + N_a - 1] \longrightarrow L'$
$N_1 + N_2 + ... + N_{n-1} + L' \leqslant N_b$ ?

KO:
$\longmapsto L'' = N_b - (N_1 + N_2 + ... + N_{n-1})$
$\longmapsto i \; exp_0$

GEN-2

$* \quad exp(n) > i \; exp_0 + N_a : ALLOC \; N_a$

$* \quad i \; exp_0 + 1 \leqslant exp(n) \leqslant i \; exp_0 + N_a : ALLOC \; \begin{vmatrix} exp(n) - i \; exp_0 \; (L'') \\ exp(n) - i \; exp_0 - 1 \; (L'-L'') \end{vmatrix}$

$* \quad exp(n) \leqslant i \; exp_0 : ALLOC \; \varnothing$

GEN-3

TER-A                    DIS              TER-B

L2[A]                                    L2[B]
LO+L1[A]        MIX                      LO+L1[B]

LO+L1[B+C]                               L2[A]
                                         LO+L1[A+C]

**FIG. 10**

                    L2[C]
                    LO+L1[C]      TER-C

                    L2[A]
                    LO+L1[A+B]

COD                                      DEC

                        C

PROC        MEM          PROC'      MEM'

**FIG. 11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010191538 A
- EP 2187387 A
- EP 2202728 A

**Littérature non-brevet citée dans la description**

- Software tools for speech and audio coding standardization. *ITU-T G. 191,* Mars 2010